# EUROPEAN PATENT APPLICATION

(11) **EP 4 510 811 A1**
(43) Date of publication of application: **19.02.2025**
(21) Application number: 22964808.4
(22) Date of filing: 10.11.2022
(51) Int. Cl.: H10K 30/50, H10K 30/86

(54) **POLYMER, PEROVSKITE SOLAR CELL, PHOTOVOLTAIC MODULE, AND ELECTRICAL DEVICE**

(71) Applicant: Contemporary Amperex Technology (Hong Kong) Limited, Central, Central And Western District (HK)
(72) Inventor: LIANG, Weifeng, Ningde, Fujian 352100 (CN); TU, Bao, Ningde, Fujian 352100 (CN); CHEN, Changsong, Ningde, Fujian 352100 (CN); SHI, Ruoxuan, Ningde, Fujian 352100 (CN); LI, Hanfang, Ningde, Fujian 352100 (CN); LUAN, Bo, Ningde, Fujian 352100 (CN); GUO, Yongsheng, Ningde, Fujian 352100 (CN); CHEN, Guodong, Ningde, Fujian 352100 (CN); OUYANG, Chuying, Ningde, Fujian 352100 (CN)
(74) Representative: Jacob, Reuben Ellis
(86) International application number: PCT/CN2022/131205
(87) International publication number: WO 2024/098339

(57) **Abstract**

The present application provides a polymer, a perovskite solar cell, a photovoltaic module, and a power consuming device. The polymer comprises repeating units represented by formula (I): -M-R-Y - formula (I), wherein in the formula (I), M is selected from substituted or unsubstituted anilino, substituted or unsubstituted carbazolyl, substituted or unsubstituted acridinyl, substituted or unsubstituted phenothiazinyl or substituted or unsubstituted phenoxazinyl; R is selected from substituted or unsubstituted C1-C10 alkyl; and Y is selected from carboxyl or a salt thereof, a phosphoric acid group or a salt thereof, or a sulfonic acid group or a salt thereof. When the polymer is used in a perovskite solar cell, the photoelectric conversion efficiency of the perovskite solar cell can be improved.

## Description

### Technical Field

The present application relates to the field of batteries, and in particular to a polymer, a perovskite solar cell, a photovoltaic module, and a power consuming device.

### Background Art

Perovskite solar cells are solar cells using an organometallic halide perovskite material as a light absorption layer, and have excellent photovoltaic properties and simple preparation methods, bringing new space and hope to photovoltaic power generation.

In the production process of perovskite solar cells, how to further improve the photovoltaic conversion efficiency of the perovskite solar cells is an urgent problem to be solved.

### Summary of the Invention

In view of the above-mentioned issue, the present application is made and aims to provide a polymer, a perovskite solar cell, a photovoltaic module, and a power consuming device.

A first aspect of the present application provides a polymer, which comprises repeating units represented by formula (I):

-M-R-Y - formula (1),

wherein in the formula (I),
M is selected from substituted or unsubstituted anilino, substituted or unsubstituted carbazolyl, substituted or unsubstituted acridinyl, substituted or unsubstituted phenothiazinyl or substituted or unsubstituted phenoxazinyl;
R is selected from substituted or unsubstituted C1-C10 alkyl;
and Y is selected from carboxyl or a salt thereof, a phosphoric acid group or a salt thereof, or a sulfonic acid group or a salt thereof.

Therefore, in the present application, Y, R and M are regarded as an organic whole. When they, as a repeating unit of a polymer, are introduced to the surface of a nickel oxide, Y can provide the polymer with effective binding sites for trivalent nickel and can passivate the trivalent nickel at the surface of the nickel oxide, and reduce the reaction between high-valent nickel such as trivalent nickel and an A-position cation, such that there is basically no residual lead halide at the interface, non-radiative recombination at the interface is reduced, and the device stability and open circuit voltage of perovskite solar cells are improved. As an intermediate medium connecting N and M, R is beneficial to evenly spreading the M group on the surface of the nickel oxide hole transport layer. The anilino group contained in M is able to regulate the functional properties of perovskite solar cells, and the hydrophobicity thereof can reduce the impact of external water and oxygen on the perovskite material, and the stability and open circuit voltage of the device are further improved, thereby the photovoltaic conversion efficiency of the perovskite solar cells is improved.

In some embodiments, R is selected from substituted or unsubstituted C1-C8 alkyl; optionally, R is selected from substituted or unsubstituted C1-C5 alkyl.

In some embodiments, the repeating unit represented by formula (I) includes one or more of repeating units represented by formula (I-1) to formula (I-7): 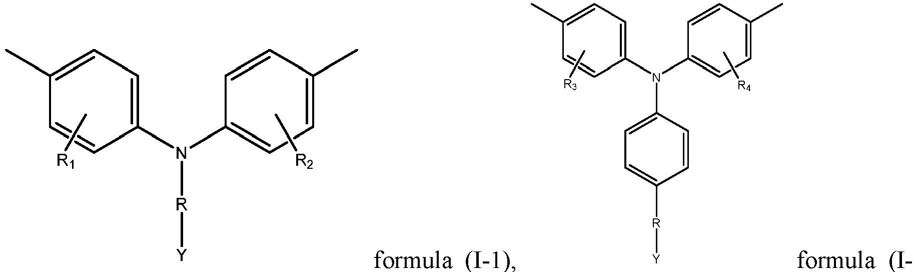 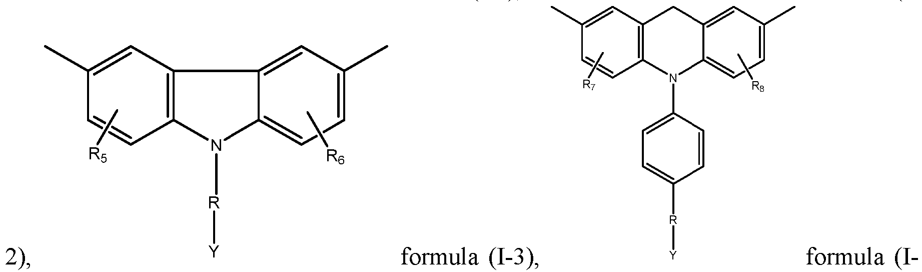 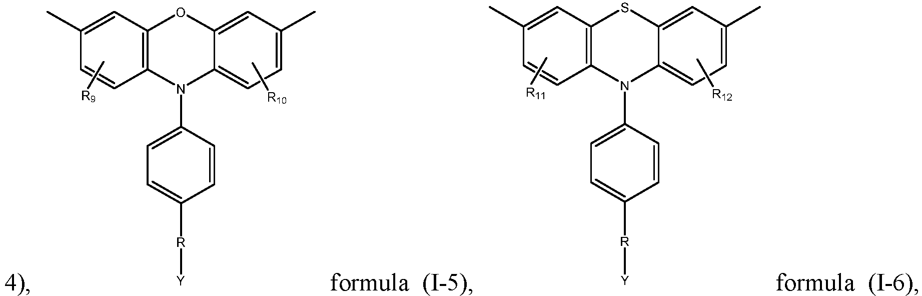 and 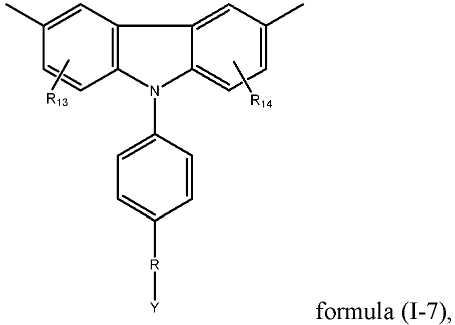
wherein, R₁ to R₁₄ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted C6-C20 aryl, optionally, when substituted, the substituent being independently selected from at least one of a halogen atom or a nitrogen-containing group;
and the nitrogen-containing group including C2-C10 dialkylamino, C1-C5 alkylamino, amino, trimethylamino, triethylamino or tripropylamino; and optionally, R₁ to R₁₄ are each independently selected from a hydrogen atom, a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl; and further optionally, R₁ to R₁₄ are each independently selected from a hydrogen atom, substituted or unsubstituted C1-C5 alkoxy or substituted or unsubstituted C1-C5 alkyl.

In some embodiments, Y in the repeating unit represented by formula (I-2) is selected from a phosphoric acid group; and optionally, the repeating unit represented by formula (I-2) includes at least one of repeating units represented by formula (I-21) to formula (I-29): 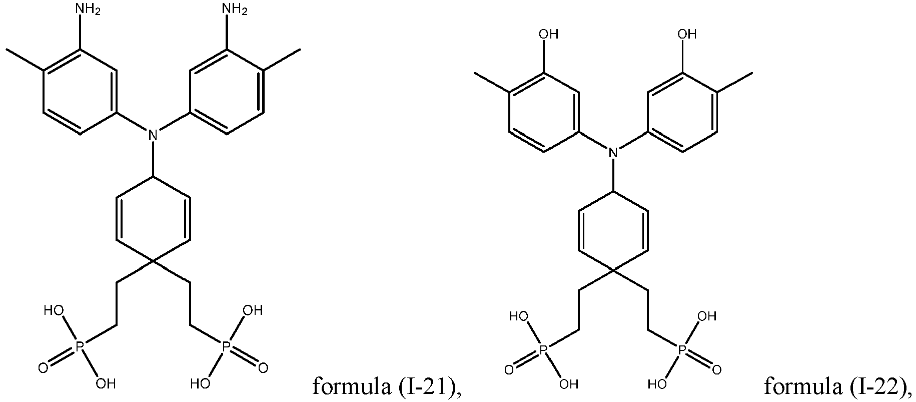 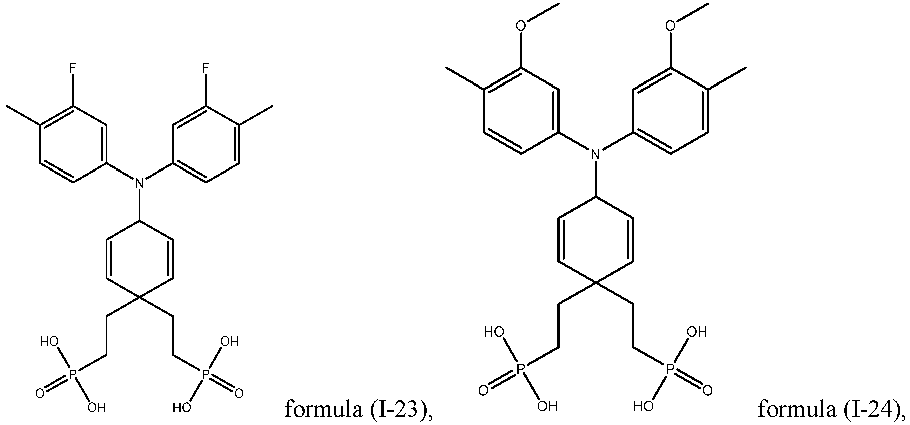 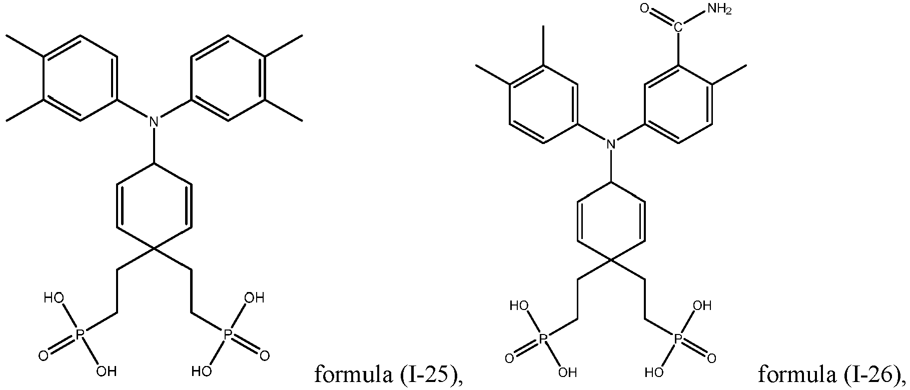 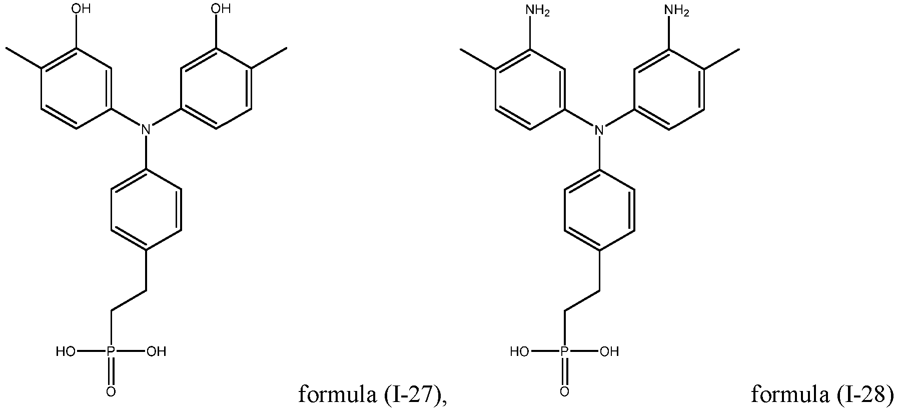 and

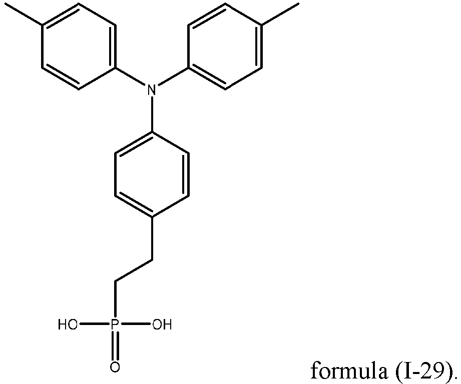

In some embodiments, the repeating unit represented by formula (I-3) includes at least one of repeating units represented by formula (1-31) to formula (1-391):

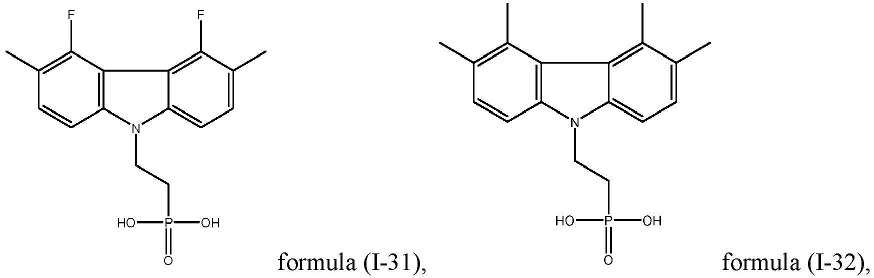

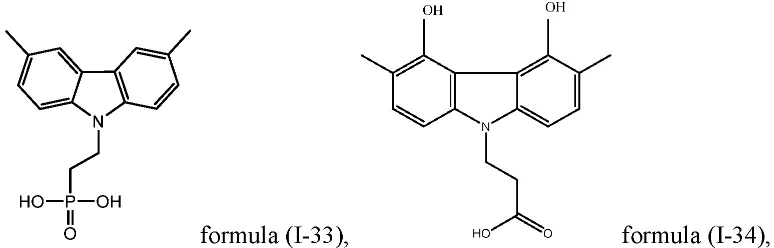

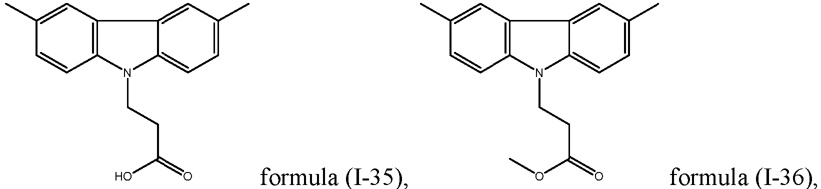

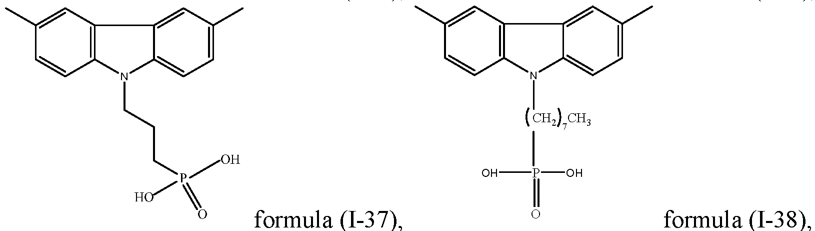

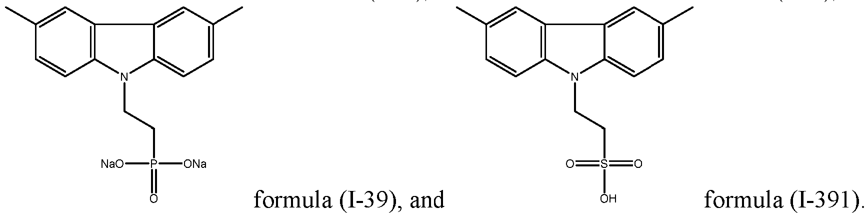

In some embodiments, the polymer has a weight average molecular weight of 3000 Da to 20000 Da; optionally, 3000 Da to 10000 Da. When the weight average molecular weight of the polymer is within the above ranges, it is possible to make the polymer evenly distribute on the nickel oxide layer and the thickness of the formed film layer can be relatively thin.

In a second aspect, the present application provides a perovskite solar cell, sequentially comprising: a hole transport layer, a passivation layer and a perovskite layer, wherein the passivation layer includes a polymer according to any one of embodiments of the first aspect of the present application, wherein the passivation layer has an LUMO energy level greater than the LUMO energy level of the perovskite layer; and optionally, the LUMO energy level of the passivation layer is located between the LUMO energy level of the perovskite layer and the LUMO energy level of the hole transport layer.

In some embodiments, the difference between the LUMO energy level of the perovskite layer and the LUMO energy level of the passivation layer is within 0.5 eV; and optionally, the difference between the LUMO energy level of the perovskite layer and the LUMO energy level of the passivation layer is within 0.3 eV.

In some embodiments, the difference between the LUMO energy level of the passivation layer and the LUMO energy level of the hole transport layer is within 0.5 eV; and optionally, the difference between the LUMO energy level of the passivation layer and the LUMO energy level of the hole transport layer is within 0.3 eV.

In some embodiments, the passivation layer has a thickness of 0.1 nm to 5 nm; optionally, 1 nm to 3 nm.

In a third aspect, the present application provides a perovskite solar cell, comprising a hole transport layer which comprises a polymer according to any one of embodiments of the first aspect of the present application.

In some embodiments, the hole transport layer has a thickness of 10 nm to 50 nm; optionally, 15 nm to 30 nm.

A fourth aspect of the present application further provides a photovoltaic module, including a perovskite solar cell according to any one of embodiments of the second aspect or the third aspect of the present application.

A fifth aspect of the present application further provides a power consuming device, including a perovskite solar cell according to any one of embodiments of the second aspect or the third aspect of the present application or a photovoltaic module of the fourth aspect.

### Brief Description of the Drawings

To more clearly illustrate the technical solutions of the embodiments of the present application, the accompanying drawings required in the embodiments of the present application will be briefly described below. Obviously, the accompanying drawings described below are merely some embodiments of the present application, and for those of ordinary skill in the art, other accompanying drawings can be obtained from these accompanying drawings without making creative efforts.
Fig. 1 shows a structural schematic diagram of a perovskite solar cell provided in some embodiments of the present application.
Fig. 2 shows a structural schematic diagram of a perovskite solar cell provided in some other embodiments of the present application.
Fig. 3 shows a structural schematic diagram of a power consuming device provided in some embodiments of the present application.

The accompanying drawings are not necessarily drawn to the actual scale.

List of reference signs:
X: thickness direction;
100. perovskite solar cell;
10. transparent electrode; 20. hole transport layer; 30. passivation layer; 40. perovskite layer; 50. electron transport layer; 60. buffer layer; 70. metal electrode;
200. power consuming device.

### Detailed Description of Embodiments

Hereinafter, embodiments of the polymer, the perovskite solar cell and the photovoltaic module of the present application are specifically disclosed in the detailed description. However, unnecessary detailed illustrations may be omitted in some instances. For example, there are situations where the detailed description of well-known items and the repeated description of actually identical structures are omitted. This is to prevent the following description from being unnecessarily verbose, and facilitates understanding by those skilled in the art. Moreover, the accompanying drawings and the descriptions below are provided for enabling those skilled in the art to fully understand the present application, rather than limiting the subject matter disclosed in the claims.

The "ranges" disclosed in the present application are defined in the form of lower and upper limits. A given range is defined by selecting a lower limit and an upper limit, and the selected lower and upper limits define the boundaries of the particular range. Ranges defined in this manner may include or exclude end values, and may be arbitrarily combined, that is, any lower limit may be combined with any upper limit to form a range. For example, if the ranges of 60-120 and 80-110 are listed for a particular parameter, it should be understood that the ranges of 60-110 and 80-120 are also contemplated. Additionally, if minimum range values 1 and 2 are listed and maximum range values 3, 4, and 5 are listed, the following ranges are all contemplated: 1-3, 1-4, 1-5, 2-3, 2-4, and 2-5. In the present application, unless stated otherwise, the numerical range "a-b" denotes an abbreviated representation of any combination of real numbers between a and b, where both a and b are real numbers. For example, the numerical range "0-5" means that all the real numbers between "0-5" have been listed herein, and "0-5" is just an abbreviated representation of combinations of these numerical values. In addition, when a parameter is expressed as an integer of ≥ 2, it is equivalent to disclosing that the parameter is, for example, an integer of 2, 3, 4, 5, 6, 7, 8, 9, 10, 11, 12, etc.

All the embodiments and optional embodiments of the present application can be combined with one another to form a new technical solution, unless otherwise stated. All the technical features and optional technical features of the present application can be combined with one another to form a new technical solution, unless otherwise stated.

Unless otherwise stated, all the steps of the present application may be carried out sequentially or randomly, preferably sequentially. For example, the method including steps (a) and (b) indicates that the method may comprise steps (a) and (b) carried out sequentially, and may also comprise steps (b) and (a) carried out sequentially. For example, reference to "the method may further comprise step (c)" indicates that step (c) may be added to the method in any order, e.g., the method may comprise steps (a), (b) and (c), may also comprise steps (a), (c) and (b), may also comprise steps (c), (a) and (b), etc.

The terms "include" and "comprise" mentioned in the present application are open-ended, but may also be closed-ended, unless otherwise stated. For example, "include" and "comprise" may mean that other components not listed may further be included or comprised, or only the listed components may be included or comprised.

In the present application, the term "or" is inclusive unless otherwise specified. For example, the phrase "A or B" means "A, B, or both A and B". More specifically, the condition "A or B" is satisfied by any one of the following: A is true (or present) and B is false (or not present); A is false (or not present) and B is true (or present); or both A and B are true (or present).

The term "anilino" includes dianilino, trianilino or carbazolyl. In addition, the anilino may be optionally substituted, and the substituent may be a halogen atom, a nitrogen atom, a sulfur atom, a phosphorus atom, alkyl, or heterocyclyl, etc.

The term "alkyl" encompasses both straight and branched chain alkyl. For example, the alkyl may be C1-C20 alkyl, C1-C12 alkyl, C1-C10 alkyl, C1-C6 alkyl, or C1-C4 alkyl. In some embodiments, the alkyl includes methyl, ethyl, propyl, isopropyl, butyl, isobutyl, sec-butyl, tert-butyl, cyclobutyl, pentyl, isopentyl, neopentyl, tert-pentyl, cyclopentyl, hexyl, cyclohexyl, heptyl, cycloheptyl, octyl, cyclooctyl, nonyl, decyl, etc. In addition, the alkyl may be optionally substituted, for example, the alkyl is substituted by a halogen atom to form haloalkyl. The term "haloalkyl" refers to alkyl in which hydrogen atoms are partly or fully replaced by halogen atoms. The term "halogen atom" refers to a fluorine atom, a chlorine atom, a bromine atom, an iodine atom, etc.

Throughout the specification, the substituents of compounds are disclosed in a manner of groups or scopes. It is explicitly expected that such a description includes each individual sub combination of the members in these groups and scopes. For example, it is explicitly expected that the term "C1-C10 alkyl" individually discloses C1, C2, C3, C4, C5, C6, C7, C8, C9, C10, C1-C10, C1-C9, C1-C8, C1- C7, C1-C6, C1-C5, C1-C4, C1-C3, C1-C2, C2-C10, C2-C9, C2-C8, C2-C7, C2-C6, C2-C5, C2-C4, C2-C3, C3-C10, C3-C9, C3-C8, C3-C7, C3-C6, C3-C5, C3-C4, C4-C10, C4-C9, C4-C8, C4-C7, C4- C6, C4-C5, C5-C10, C5-C9, C5-C8, C5-C7, C5-C6, C6-C10, C6-C9, C6-C8, C6-C7, C7-C10, C7-C9, C7-C8, C8-C10 and C8-C9 alkyl.

The term "alkoxy" refers to a group in which an alkyl group is linked to an oxygen atom via a single bond. For example, the alkoxy may be C1-C10 alkoxy, C1-C8 alkoxy, C1-C5 alkoxy, or C2-C6 alkoxy. In some embodiments, the alkoxy can include methoxy, ethoxy, propoxy, butoxy, isobutoxy, sec-butoxy, tert-butoxy, cyclobutoxy, pentoxy, isopentoxy, neopentoxy, tert-pentoxy, and cyclopentoxy.

The term "amido" refers to a group formed by replacing the hydroxyl group in the carboxyl group with an amino or amine group. For example, the amido may be C1-C10 amido, C1-C8 amido, C1-C5 amido, C2-C5 amido, or C3-C5 amido. In some embodiments, the amido includes formamido, acetamido, propionamido, butyramido, isobutyramido, sec-butyramido, tert-butyramido, cyclobutyramido, valeramido, isovaleramido, pivalamido, tert-valeramido, and cyclovaleramido.

The term "ester group" refers to an ester functional group in carboxylic acid derivatives. For example, the ester group may be a C1-C10 ester group, a C1-C8 ester group, a C1-C5 ester group, a C2-C5 ester group, or a C3-C5 ester group. In some embodiments, the ester group includes a methyl ester group, an ethyl ester group, a propyl ester group, a butyl ester group, an isobutyl ester group, a sec-butyl ester group, a tert-butyl ester group, a cyclobutyl ester group, a pentyl ester group, an isopentyl ester group, a neopentyl ester group, a tert-pentyl ester group, and a cyclo-pentyl ester group.

The term "carboxyalkyl" refers to a group in which an alkyl group is linked to a carboxyl group via a single bond. For example, the carboxyalkyl may be C1-C10 carboxyalkyl, C1-C8 carboxyalkyl, C1-C5 carboxyalkyl, C2-C5 carboxyalkyl, or C3-C5 carboxyalkyl. In some embodiments, the carboxyalkyl includes carboxymethyl, carboxyethyl, carboxypropyl, carboxybutyl, carboxyisobutyl, carboxysec-butyl, carboxytert-butyl, carboxycyclobutyl, carboxypentyl, carboxyisopentyl, carboxyneopentyl, carboxytert-pentyl, and carboxycyclopentyl.

The term "aryl" refers to a closed aromatic ring or ring system. For example, the aryl can be C6-C50 aryl, C6-C40 aryl, C6-C30 aryl, C6-C20 aryl, or C6-C10 aryl, wherein the C6-C20 aryl refers to a group containing 6-20 carbon atoms for forming a ring. In some embodiments, the aryl includes phenyl, naphthyl, phenanthrenyl, anthracenyl, biphenyl, triphenylene, pyrenyl, spirobifluorenyl, perylenyl, indenyl, azulenyl, etc.

The term "dialkylamino" refers to a group formed by replacing two hydrogen atoms of an amino group with two alkyl groups. For example, the dialkylamino may be C2-C20 dialkylamino, C2-C10 dialkylamino, C4-C10 dialkylamino, or C4-C6 dialkylamino. In some embodiments, the dialkylamino includes dimethylamino, diethylamino, dipropylamino, dibutylamino, diisobutylamino, di-sec-butylamino, di-tert-butylamino, dicyclobutylamino, dipentylamino, diisopentylamino, dineopentylamino, di-tert-pentylamino, and dicyclopentylamino.

The term "alkylamino" refers to a group formed by replacing one hydrogen atom of an amino group with one alkyl group. For example, the alkylamino may be C2-C20 alkylamino, C2-C10 alkylamino, C4-C10 alkylamino, or C4-C6 alkylamino. In some embodiments, the alkylamino includes methylamino, ethylamino, propylamino, butylamino, isobutylamino, sec-butylamino, tert-butylamino, cyclobutylamino, pentylamino, isopentylamino, neopentylamino, tert-pentylamino, and cyclopentylamino.

The term "halogen atom" refers to a fluorine atom, a chlorine atom, a bromine atom, etc.

The term "hydrogen" refers to 1H (protium, H), 2H (deuterium, D) or 3H (tritium, T). In various embodiments, "hydrogen" may be 1H (protium, H).

In the present application, the term "a plurality of" refers to two or more.

The perovskite solar cell includes a perovskite layer, a hole transport layer, an electron transport layer, and electrodes. A working process of the perovskite cell mainly includes: the generation and separation of excitons, the transport of free carriers, the collection of carriers and the generation of electric current. The specific process is as follows: in perovskite solar cells, sunlight is absorbed by the perovskite layer, the perovskite layer absorbs photons to generate excitons, which are subsequently separated into free electrons and holes due to the relatively low Coulomb force binding of the perovskite layer; the separated free carriers are transported in the perovskite layer and transported out by the transport layers, wherein the electron transport layer plays the role of transporting electrons and blocking holes, and the hole transport layer plays the role of transporting holes and blocking electrons; and the electrons and holes transported by the transport layers are collected by the electrodes to form current and voltage, respectively.

The perovskite solar cell mainly includes an upright structure and an inverted structure. The order of the functional layers of the device with an upright structure through which the incident light passes are the electron transport layer, the perovskite layer, and the hole transport layer, respectively. The order of the functional layers of the device with an inverted structure through which the incident light passes are the hole transport layer, the perovskite layer, and the electron transport layer, respectively. Hereinafter, the device with an inverted structure is taken as an example for illustration.

The ideal perovskite structure is ABX₃ or A₂CDX₆. ABX₃ is taken as an example for illustration, wherein BX₆ constitutes a regular octahedron, and is connected to each other by means of a shared vertice X, forming a three-dimensional skeleton, and A is embedded in the octahedral void to stabilize the crystal structure. A is a large-radius cation, B is a small-radius cation, and X is an anion. Because the type and amount of elements that can be accommodated at the positions A, B and X have very wide ranges, there is a relatively large variety of compounds with a perovskite structure.

As a commonly used inorganic hole transport layer material, a nickel oxide, NiOₓ, has a cubic structure similar to that of NaCl. During the preparation of NiO, both the NiOOH and Ni₂O₃ will be also present in the nickel oxide due to the requirement of adding excess oxygen, wherein the excess oxygen causes a certain number of Ni vacancies in the nickel oxide, NiOx, thus generating holes, such that the nickel oxide can serve as a P-type semiconductor, and nickel oxide has an appropriate charge carrier migration rate and an appropriate work function. Because the nickel oxide has a very high light transmittance in the near-ultraviolet and visible light bands, it can be used as an excellent hole transport layer material. The valence band tops of the nickel oxide and the perovskite material are relatively matched, thus the photoexcited holes in the perovskite can be smoothly transferred to the hole transport layer.

However, the inventors have found by means of researches that when a nickel oxide hole transport layer is used as the hole transport layer, the surface of the nickel oxide hole transport layer contains oxidizing trivalent nickel ions, which easily react with the A-position cation in the perovskite layer, such that there are vacancies in the A-position, excess lead halide remains at the interface, the non-radiative recombination at the interface is increased, and the open circuit voltage of the perovskite solar cell is reduced. Moreover, the lead halide will lead to the degradation of the perovskite material, such that the overall stability of the perovskite solar cell is relatively poor, and the open circuit voltage of the perovskite solar cell is further reduced, thereby the photoelectric conversion efficiency of the perovskite solar cell is relatively low.

Aiming at the above problems, from the perspective of improving the performance of the hole transport layer, the inventors have achieved the improvement of the overall stability and open circuit voltage of the perovskite solar cell, thereby improving the photoelectric conversion efficiency of the perovskite solar cell.

### Polymer

In a first aspect, the present application provides a polymer.

The polymer comprises repeating units represented by formula (I):

-M-R-Y - formula (1),

wherein in the formula (I),
M is selected from substituted or unsubstituted anilino, substituted or unsubstituted carbazolyl, substituted or unsubstituted acridinyl, substituted or unsubstituted phenothiazinyl or substituted or unsubstituted phenoxazinyl;
R is selected from substituted or unsubstituted C1-C10 alkyl;
and Y is selected from carboxyl or a salt thereof, a phosphoric acid group or a salt thereof, or a sulfonic acid group or a salt thereof.

The structure represented by formula (I) can be considered to include three parts, i.e. M, R and Y. Y includes a carboxyl group or a salt thereof, a phosphoric acid group or a salt thereof, or a sulfonic acid group or a salt thereof. When the polymer is used in perovskite solar cells, Y can be used as a binding active site for trivalent nickel, such that the polymer can be directionally binded with trivalent nickel in the nickel oxide hole transport layer, and the polymer can evenly spread on the surface of the nickel oxide hole transport layer. Optionally, the metal cation of the salt can be selected from a sodium ion, a potassium ion, etc. Exemplarily, Y may include carboxyl, sodium carboxylate, potassium carboxylate, etc. By adjusting the Y group, the binding capacity of the Y group to trivalent nickel can be regulated, such that the performance of perovskite solar cells can be better improved.

R is selected from substituted or unsubstituted C1-C10 alkyl. When the polymer is used in perovskite solar cells, R can reduce the steric hindrance. Optionally, R is selected from substituted or unsubstituted C1-C8 alkyl. Further optionally, R is selected from substituted or unsubstituted C3-C5 alkyl. The type of alkyl is not specifically limited and can be selected according to actual requirements. For example, both chain alkyl groups and cyclic alkyl groups can be used. Chain alkyl groups include straight chain alkyl groups and branched chain alkyl groups. In addition, the cyclic alkyl group may or may not contain a substituent. C1-C10 alkyl can be selected from one of methyl, ethyl, n-propyl, isopropyl, cyclopropyl, n-butyl, isobutyl, sec-butyl, tert-butyl, n-pentyl, isopentyl, neopentyl, cyclopentyl, n-hexyl, isohexyl, cyclohexyl, heptyl, cycloheptyl, octyl, cyclooctyl, nonyl and decyl.

M is selected from substituted or unsubstituted anilino, substituted or unsubstituted carbazolyl, substituted or unsubstituted acridinyl, substituted or unsubstituted phenothiazinyl or substituted or unsubstituted phenoxazinyl. The introduction of M plays an important role in enhancing the charge transport properties of hole transport materials and improving the performance of perovskite solar cells. The anilino group has an energy level that matches the perovskite material, and has the advantages such as a good solubility, a higher hole migration rate, effective hole extraction and electron blocking. The type of M is not specifically limited and can be selected according to actual requirements. For example, M is selected from dianilino, trianilino, carbazolyl, acridinyl, phenothiazinyl, or phenoxazinyl, etc.

Y, R and M are regarded as an organic whole. When they, as a repeating unit of a polymer, are introduced to a perovskite solar cell, the polymer can be used as the material of the hole transport layer to improve the charge transport properties of the hole transport material, thereby improving the photoelectric conversion efficiency of the perovskite solar cell. When the polymer, as a passivation layer for a nickel oxide hole transport layer, is introduced to the perovskite solar cell, Y can provide the polymer with effective binding sites for trivalent nickel and can passivate the trivalent nickel at the surface of the nickel oxide, and reduce the reaction between high-valent nickel such as trivalent nickel and an A-position cation, such that there is basically no residual lead halide at the interface, non-radiative recombination at the interface is reduced, and the device stability and open circuit voltage of perovskite solar cells are improved. As an intermediate medium connecting N and M, R is beneficial to evenly spreading the M group on the surface of the nickel oxide hole transport layer. The anilino group contained in M is able to regulate the functional properties of perovskite solar cells, and the hydrophobicity thereof can reduce the impact of external water and oxygen on the perovskite material, and the stability and open circuit voltage of the device are further improved, thereby the photovoltaic conversion efficiency of the perovskite solar cells is improved.

In some embodiments, R is selected from substituted or unsubstituted C1-C8 alkyl; optionally, R is selected from substituted or unsubstituted C1-C5 alkyl. Exemplarily, R is selected from methyl, ethyl, propyl, isopropyl, butyl, isobutyl, sec-butyl, tert-butyl, cyclobutyl, pentyl, isopentyl, neopentyl, tert-pentyl or cyclopentyl.

In some embodiments, M can be selected from substituted or unsubstituted dianilino. Correspondingly, the repeating unit represented by formula (I) includes a repeating unit represented by formula (I-1): 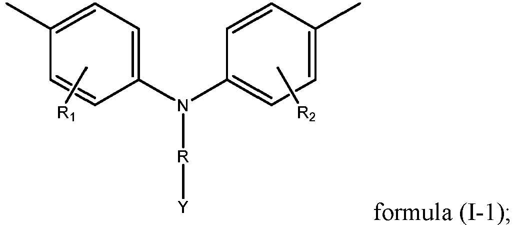
wherein, R₁ and R₂ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted aryl,
the nitrogen-containing group including C2-C10 dialkylamino, C1-C5 alkylamino, amino, trimethylamino, triethylamino or tripropylamino,
optionally, when the above groups are substituted, the substituent may be at least one of a halogen atom or a nitrogen-containing group.

Optionally, R₁ and R₂ are each independently selected from a hydrogen atom, a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl. Atoms such as nitrogen, oxygen, and fluorine are conducive to forming a hydrogen bond with the A-position structure in the perovskite structure, such that the structural stability can be improved.

Further optionally, R₁ and R₂ are each independently selected from a hydrogen atom, substituted or unsubstituted C1-C5 alkoxy or substituted or unsubstituted C1-C5 alkyl. The alkoxy or alkyl group has a better hydrophobicity which is beneficial to improving the long-term stability of perovskite solar cells.

Exemplarily, R₁ and R₂ are each independently selected from a hydrogen atom,a fluorine atom, alkoxy, alkyl, an ester group, amido, primary amino, secondary amino or tertiary amino.

Optionally, Y is selected from a phosphoric acid group.

Exemplarily, the repeating unit represented by formula (I-1) includes at least one of repeating units represented by formula (I-11) to formula (I-16): 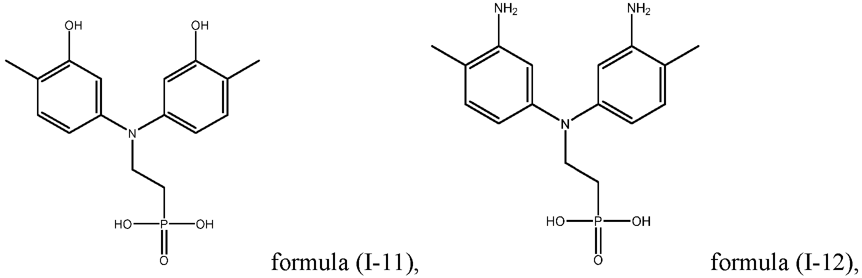 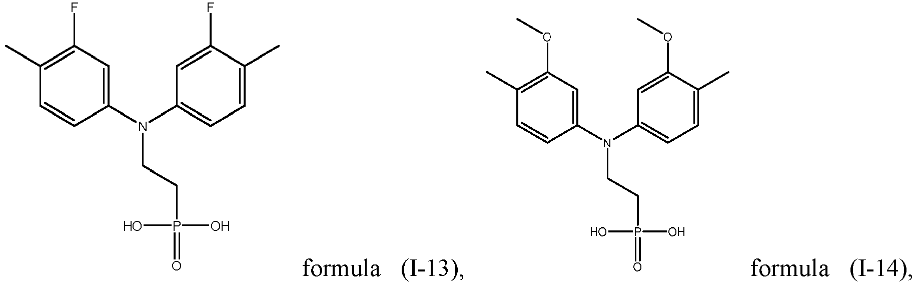 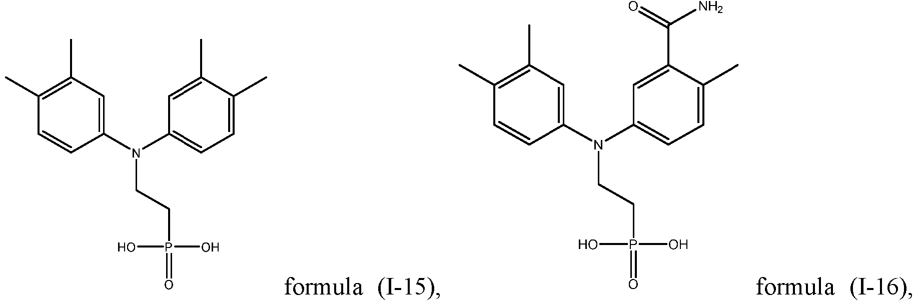 and

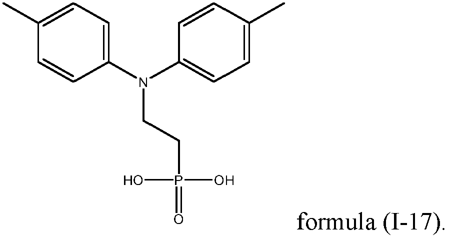

In some embodiments, M can be selected from substituted or unsubstituted trianilino. Correspondingly, the repeating unit represented by formula (I) includes a repeating unit represented by formula (I-2): 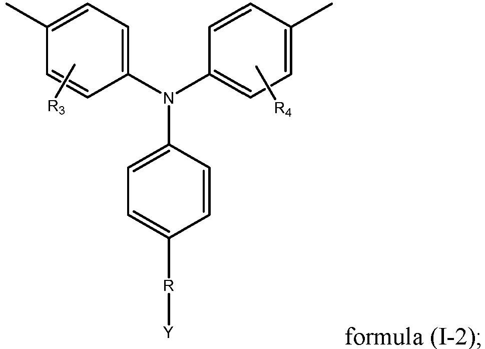
wherein, R₃ and R₄ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted aryl,
the nitrogen-containing group including C2-C10 dialkylamino, C1-C5 alkylamino, amino, trimethylamino, triethylamino or tripropylamino,
optionally, when the above groups are substituted, the substituent may be at least one of a halogen atom or a nitrogen-containing group.

Optionally, R₃ and R₄ are each independently selected from a hydrogen atom, a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl. Atoms such as nitrogen, oxygen, and fluorine are conducive to forming a hydrogen bond with the A-position structure in the perovskite structure, such that the structural stability can be improved.

Optionally, R₃ and R₄ are each independently selected from a hydrogen atom, substituted or unsubstituted C1-C5 alkoxy or substituted or unsubstituted C1-C5 alkyl. The alkoxy or alkyl group has a better hydrophobicity which is beneficial to improving the long-term stability of perovskite solar cells.

Exemplarily, R₃ and R₄ are each independently selected from a hydrogen atom, a fluorine atom, alkoxy, alkyl, an ester group, amido, primary amino, secondary amino or tertiary amino.

Optionally, Y is selected from a phosphoric acid group.

Exemplarily, the repeating unit represented by formula (I-2) includes at least one of repeating units represented by formula (I-21) to formula (I-29): 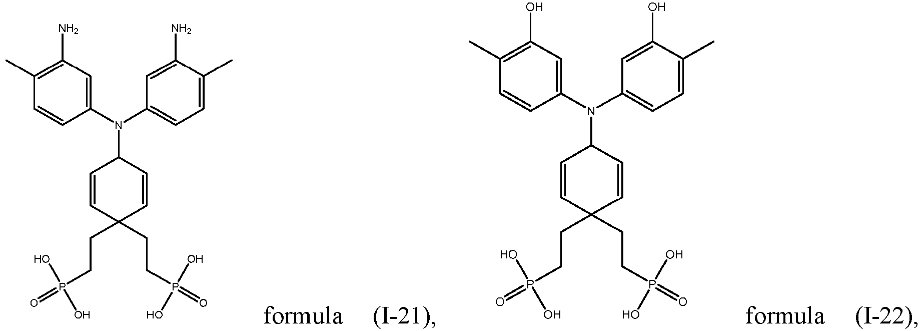 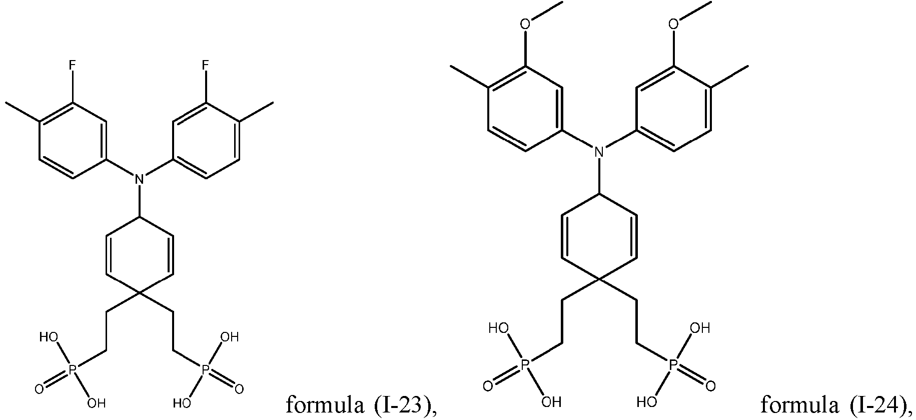 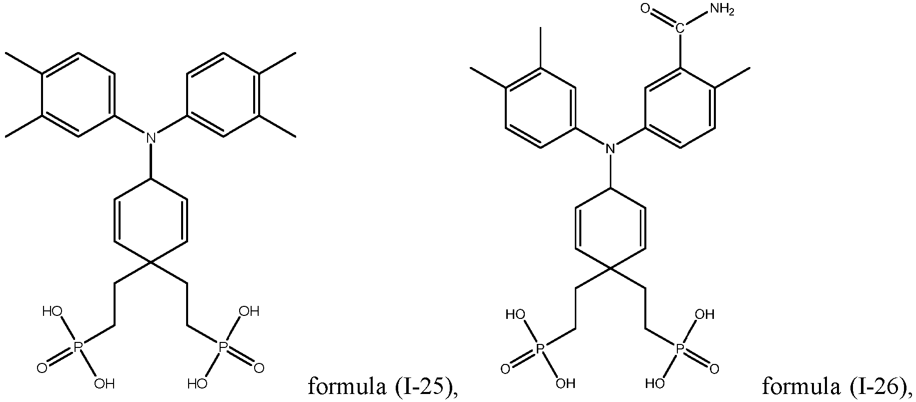 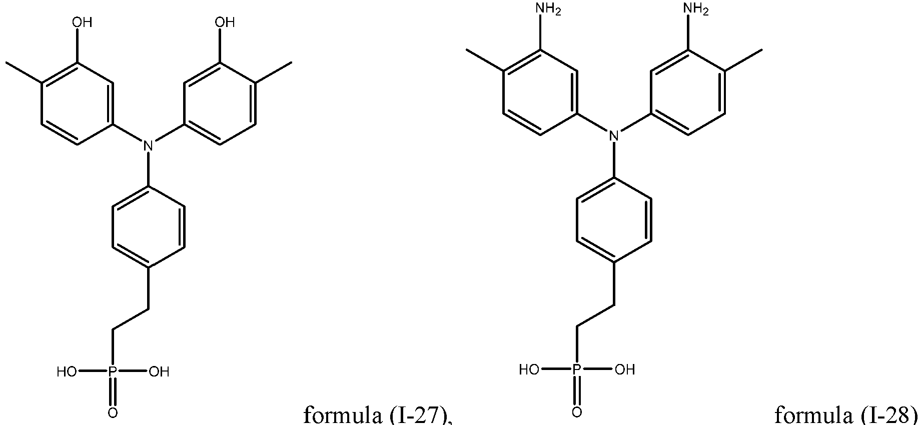 and

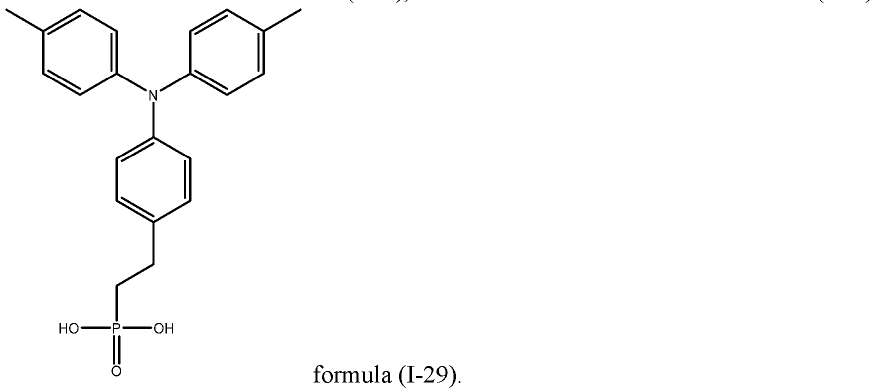

In some embodiments, M can be selected from substituted or unsubstituted carbazolyl. Correspondingly, the repeating unit represented by formula (I) includes a repeating unit represented by formula (I-3): 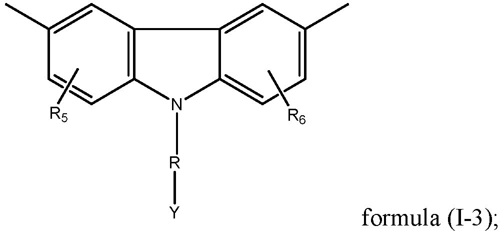
wherein, R₅ and R₆ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted aryl,
the nitrogen-containing group including C2-C10 dialkylamino, C1-C5 alkylamino, amino, trimethylamino, triethylamino or tripropylamino,
optionally, when the above groups are substituted, the substituent may be a halogen atom or a nitrogen-containing group.

Optionally, R₅ and R₆ are each independently selected from a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl. Atoms such as nitrogen, oxygen, and fluorine are conducive to forming a hydrogen bond with the A-position structure in the perovskite structure, such that the structural stability can be improved.

Optionally, R₅ and R₆ are each independently selected from substituted or unsubstituted C1-C5 alkoxy or substituted or unsubstituted C1-C5 alkyl. The alkoxy or alkyl group has a better hydrophobicity which is beneficial to improving the long-term stability of perovskite solar cells.

Exemplarily, R₅ and R₆ are each independently selected from a hydrogen atom,a fluorine atom, alkoxy, alkyl, an ester group, amido, primary amino, secondary amino or tertiary amino.

Optionally, R is selected from methyl or ethyl.

Optionally, Y is selected from a phosphoric acid group or a salt thereof, a carboxyl group or a sulfonic acid group.

Exemplarily, the repeating unit represented by formula (I-3) includes at least one of repeating units represented by formula (1-31) to formula (1-391):

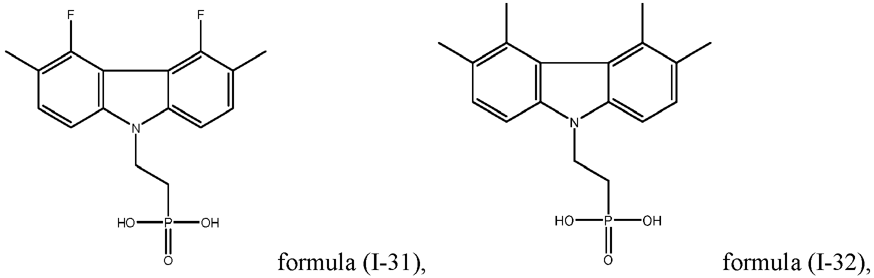

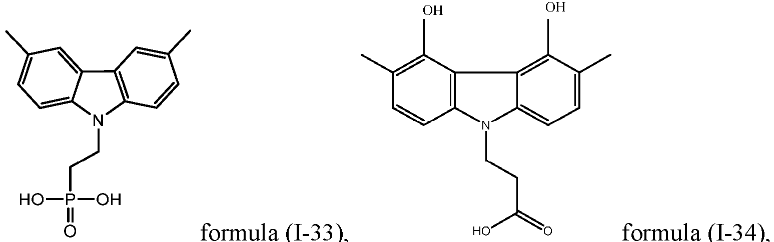

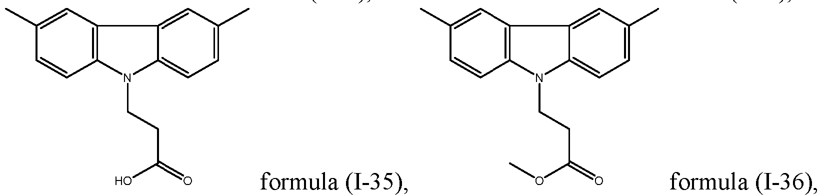

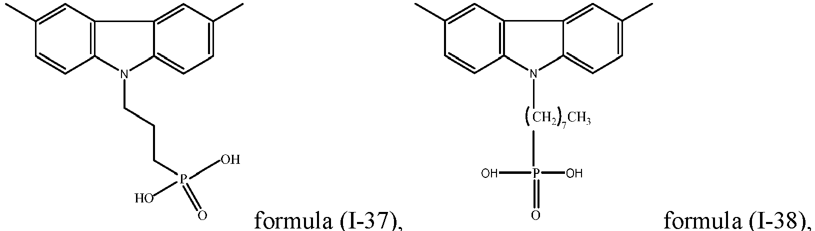

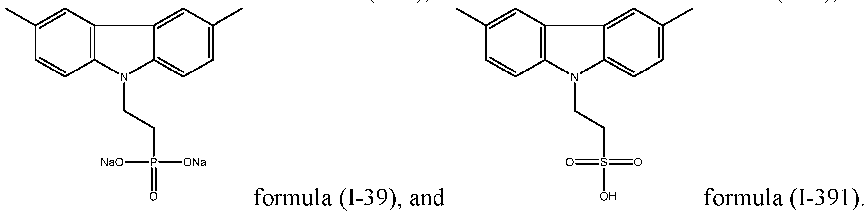

In some embodiments, the repeating unit represented by formula (I) may include a repeating unit represented by formula (I-4): 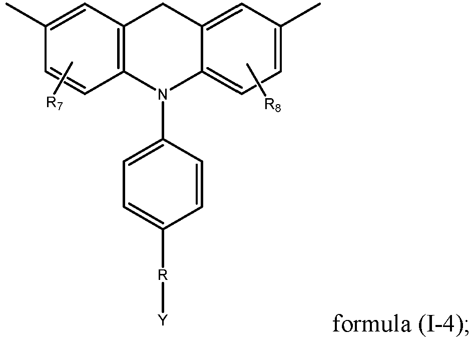
wherein, R₇ and R₈ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted aryl,
the nitrogen-containing group including C2-C10 dialkylamino, C1-C5 alkylamino, amino, trimethylamino, triethylamino or tripropylamino,
optionally, when the above groups are substituted, the substituent may be a halogen atom or a nitrogen-containing group.

R₇ and R₈ are each independently selected from a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl. Atoms such as nitrogen, oxygen, and fluorine are conducive to forming a hydrogen bond with the A-position structure in the perovskite structure, such that the structural stability can be improved.

Optionally, R₇ and R₈ are each independently selected from substituted or unsubstituted C1-C5 alkoxy or substituted or unsubstituted C1-C5 alkyl. The alkoxy or alkyl group has a better hydrophobicity which is beneficial to improving the long-term stability of perovskite solar cells.

Optionally, Y is selected from a phosphoric acid group, etc.

For example, the repeating unit represented by formula (I-4) includes one or more of repeating units represented by formula (I-41) to formula (I-49):

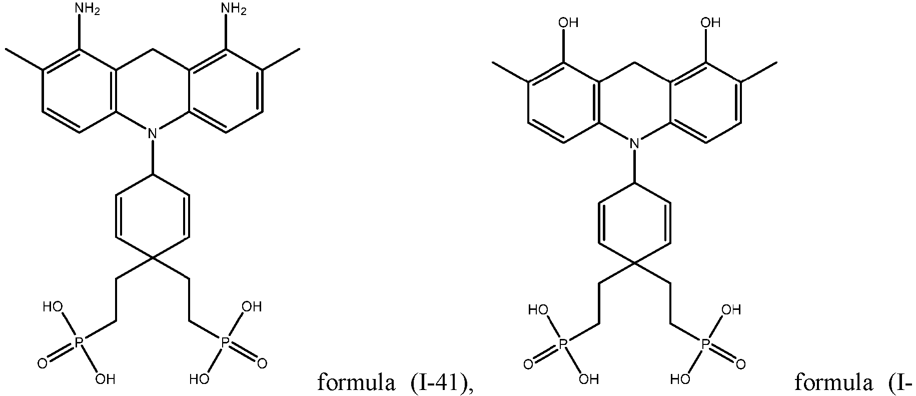

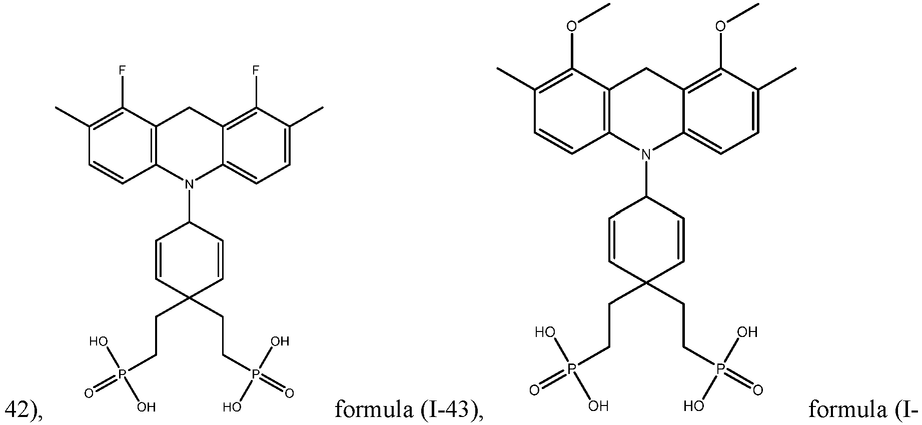

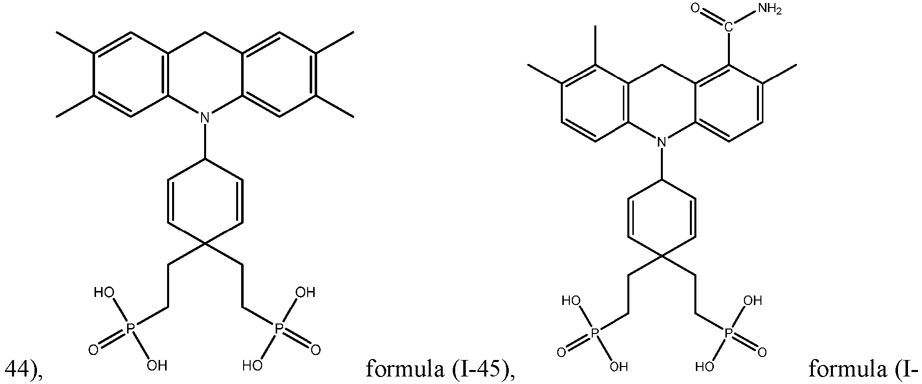

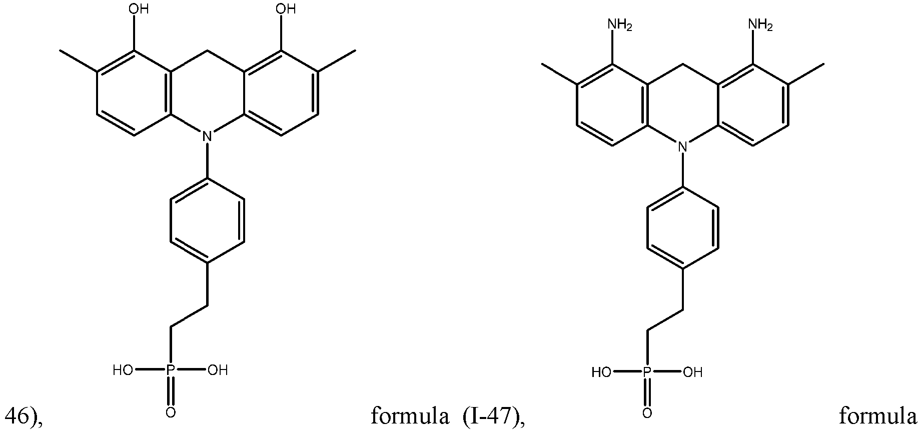

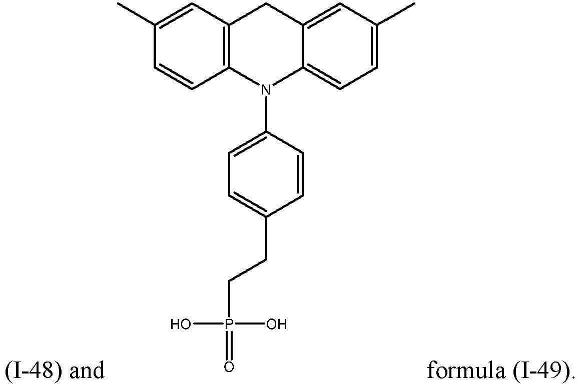

In some embodiments, the repeating unit represented by formula (I) may include a repeating unit represented by formula (I-5): 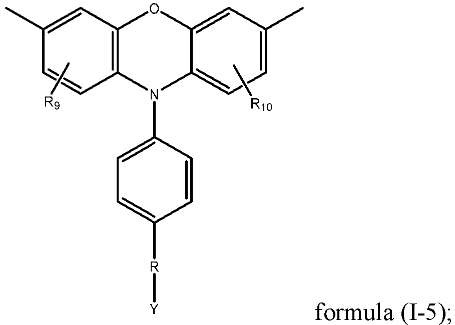
wherein, R₉ and R₁₀ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted aryl,
the nitrogen-containing group including C2-C10 dialkylamino, C1-C5 alkylamino, amino, trimethylamino, triethylamino or tripropylamino,
optionally, when the above groups are substituted, the substituent may be a halogen atom or a nitrogen-containing group.

R₉ and R₁₀ are each independently selected from a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl. Atoms such as nitrogen, oxygen, and fluorine are conducive to forming a hydrogen bond with the A-position structure in the perovskite structure, such that the structural stability can be improved.

Optionally, R₉ and R₁₀ are each independently selected from substituted or unsubstituted C1-C5 alkoxy or substituted or unsubstituted C1-C5 alkyl. The alkoxy or alkyl group has a better hydrophobicity which is beneficial to improving the long-term stability of perovskite solar cells.

Optionally, Y is selected from a phosphoric acid group, etc.

For example, the repeating unit represented by formula (I-5) includes one or more of repeating units represented by formula (I-51) to formula (I-59): 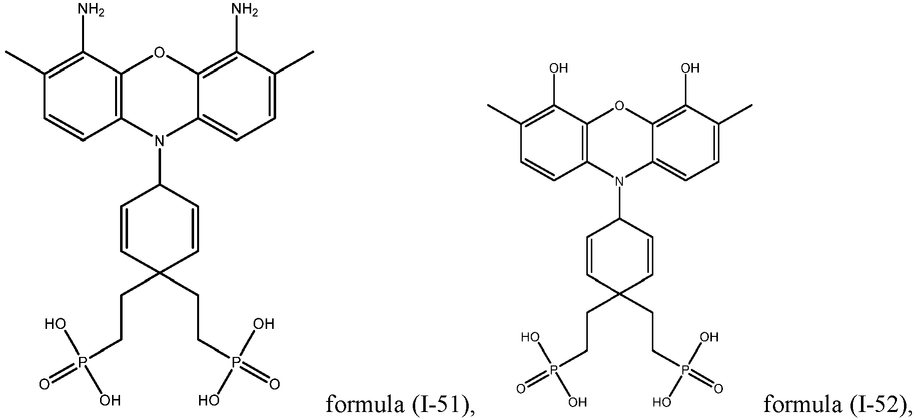 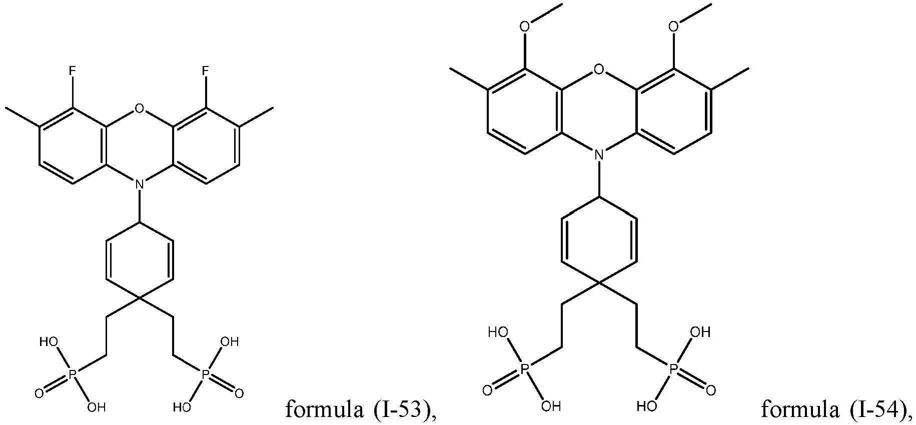 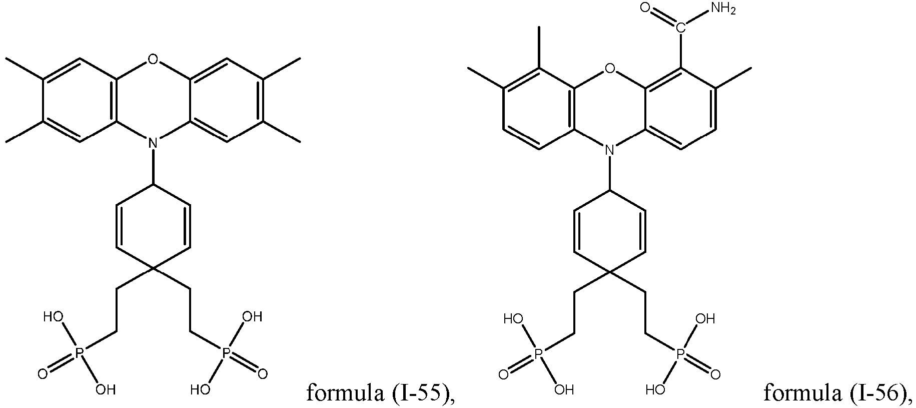 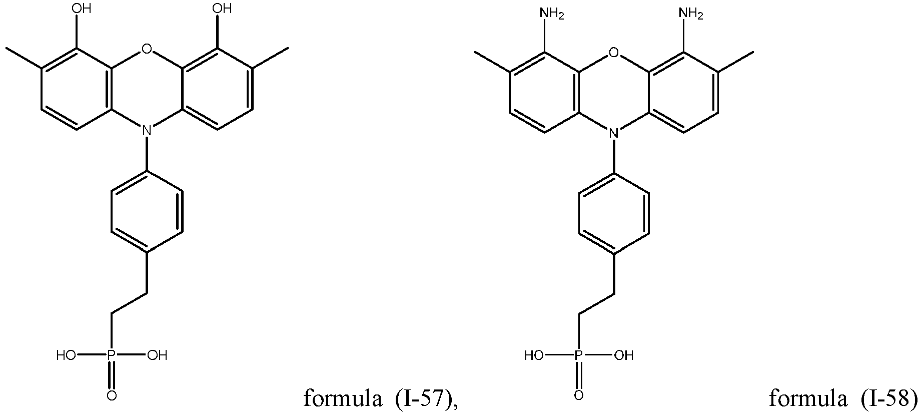 and

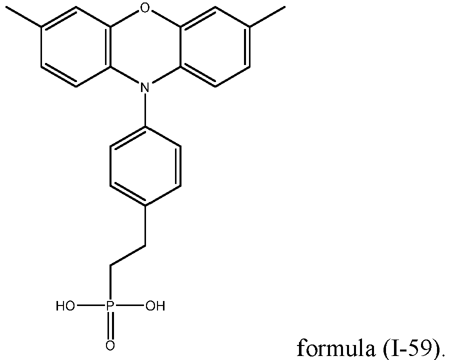

In some embodiments, the repeating unit represented by formula (I) may include a repeating unit represented by formula (I-6): 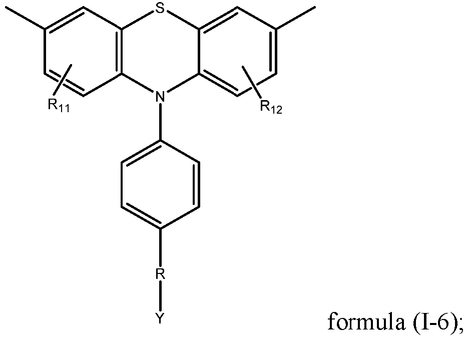
wherein, R₁₁ and R₁₂ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted aryl,
the nitrogen-containing group including C2-C10 dialkylamino, C1-C5 alkylamino, amino, trimethylamino, triethylamino or tripropylamino,
optionally, when the above groups are substituted, the substituent may be a halogen atom or a nitrogen-containing group.

R₁₁ and R₁₂ are each independently selected from a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl. Atoms such as nitrogen, oxygen, and fluorine are conducive to forming a hydrogen bond with the A-position structure in the perovskite structure, such that the structural stability can be improved.

Optionally, R₁₁and R₁₂ are each independently selected from substituted or unsubstituted C1-C5 alkoxy or substituted or unsubstituted C1-C5 alkyl. The alkoxy or alkyl group has a better hydrophobicity which is beneficial to improving the long-term stability of perovskite solar cells.

Optionally, Y is selected from a phosphoric acid group, etc. For example, the repeating unit represented by formula (I-6) includes one or more of repeating units represented by formula (I-61) to formula (I-69):

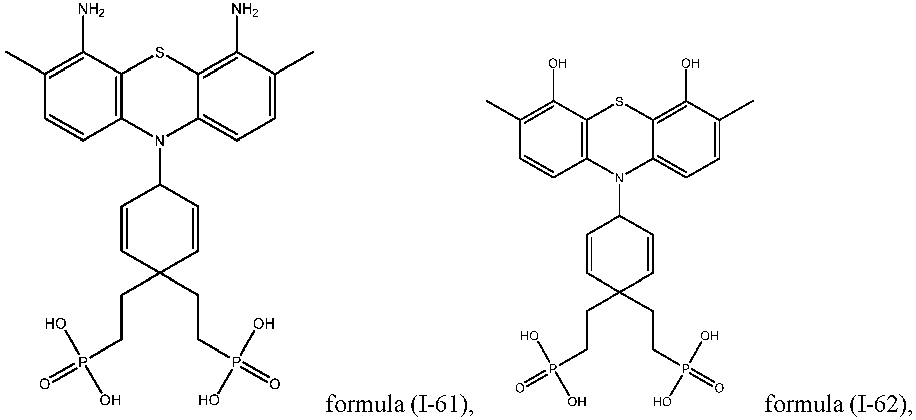

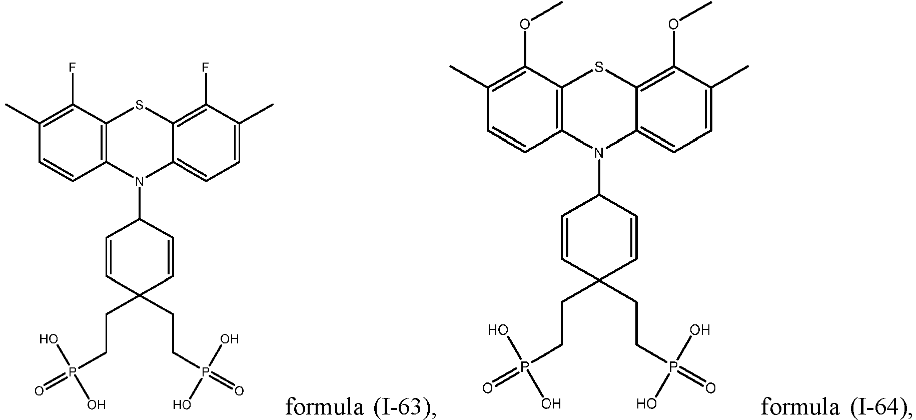

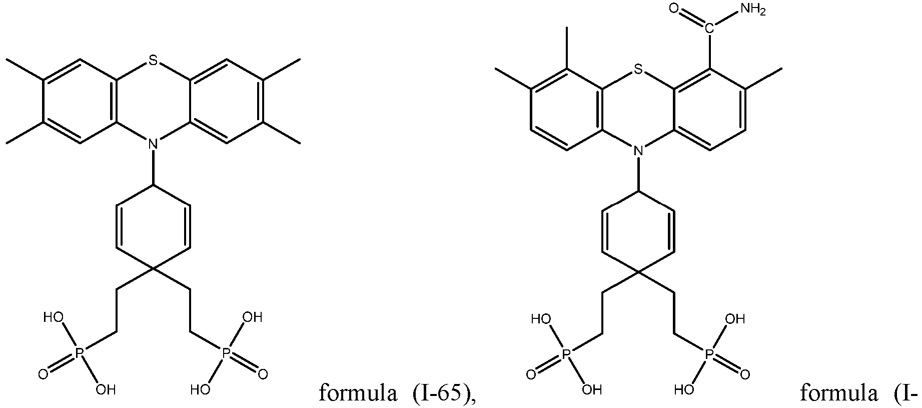

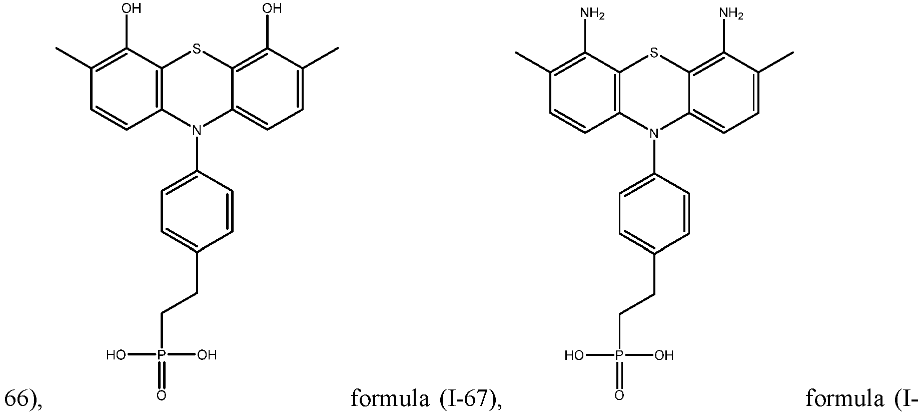

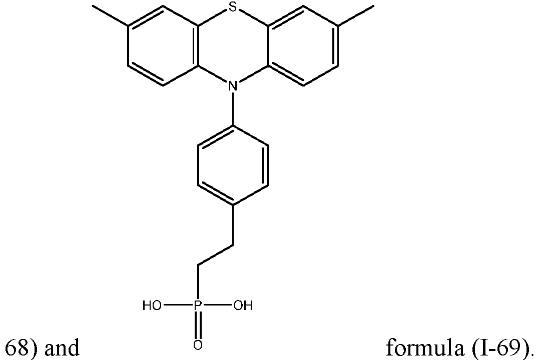

In some embodiments, the repeating unit represented by formula (I) may include a repeating unit represented by formula (I-7): 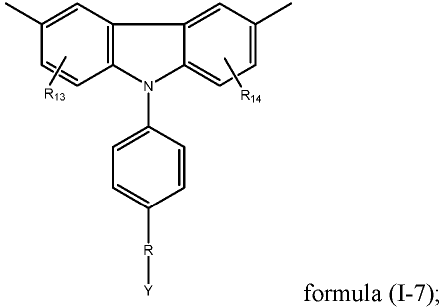
wherein, R₁₃ and R₁₄ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted aryl,
the nitrogen-containing group including C2-C10 dialkylamino, C1-C5 alkylamino, amino, trimethylamino, triethylamino or tripropylamino,
optionally, when the above groups are substituted, the substituent may be a halogen atom or a nitrogen-containing group.

R₁₃ and R₁₄ are each independently selected from a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl. Atoms such as nitrogen, oxygen, and fluorine are conducive to forming a hydrogen bond with the A-position structure in the perovskite structure, such that the structural stability can be improved.

Optionally, R₁₃ and R₁₄ are each independently selected from substituted or unsubstituted C1-C5 alkoxy or substituted or unsubstituted C1-C5 alkyl. The alkoxy or alkyl group has a better hydrophobicity which is beneficial to improving the long-term stability of perovskite solar cells.

Optionally, Y is selected from a phosphoric acid group, etc. For example, the repeating unit represented by formula (I-7) includes one or more of repeating units represented by formula (I-71) to formula (I-79): 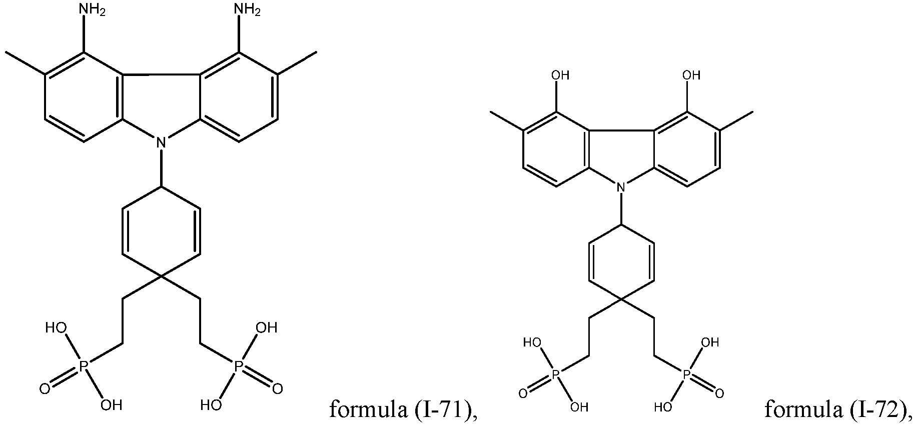 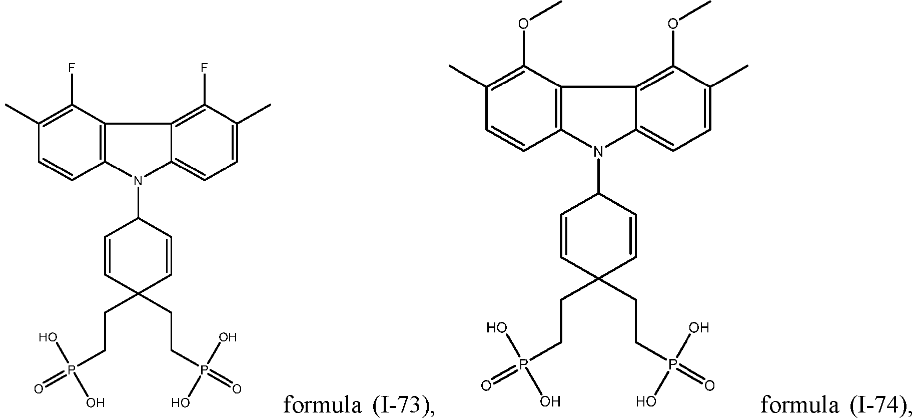 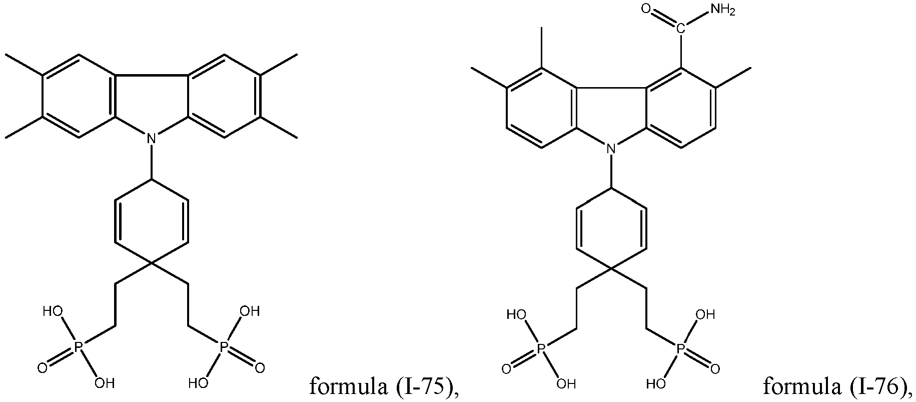 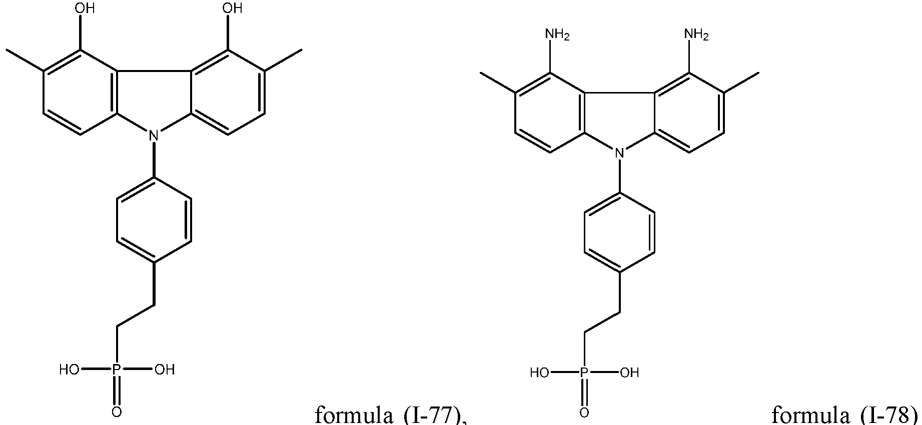 and

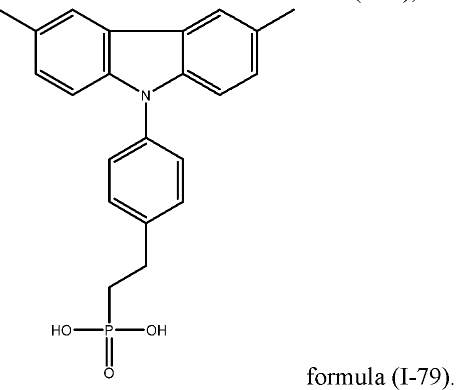

In some embodiments, the polymer has a weight average molecular weight of 3000 Da to 20000 Da; optionally, 3000 Da to 10000 Da.

When the weight average molecular weight of the polymer is within the above ranges, it is possible to make the polymer evenly distribute on the nickel oxide layer and the thickness of the formed film layer can be relatively thin.

### Perovskite solar cell

In a second aspect, the present application further provides a perovskite solar cell. The perovskite solar cell sequentially comprises a hole transport layer, a passivation layer and a perovskite layer, wherein the passivation layer includes a polymer according to any one of embodiments of the first aspect of the present application.

The passivation layer has an LUMO energy level greater than the LUMO energy level of the perovskite layer; and
optionally, the LUMO energy level of the passivation layer is located between the LUMO energy level of the perovskite layer and the LUMO energy level of the hole transport layer.

In some embodiments, the difference between the LUMO energy level of the perovskite layer and the LUMO energy level of the passivation layer is within 0.5 eV; and optionally, the difference between the LUMO energy level of the perovskite layer and the LUMO energy level of the passivation layer is within 0.3 eV.

In some embodiments, the difference between the LUMO energy level of the passivation layer and the LUMO energy level of the hole transport layer is within 0.5 eV; and optionally, the difference between the LUMO energy level of the passivation layer and the LUMO energy level of the hole transport layer is within 0.3 eV.

The LUMO energy level refers to the Lowest Unoccupied Molecular Orbital.

The difference between the LUMO energy level of the perovskite layer, the LUMO energy level of the hole transport layer and the LUMO energy level of the passivation layer meets the above conditions, such that the above polymer can be used as a passivation layer between the hole transport layer and the perovskite layer. Moreover, the polymer can effectively extract holes and block the electron transport, and has a relatively high hole migration rate.

Optionally, the hole transport layer includes a nickel oxide hole transport layer. A passivation layer is introduced between the nickel oxide hole transport layer and the perovskite layer. The passivation layer can passivate trivalent nickel, such that the risk of reaction between trivalent nickel in the nickel oxide and the perovskite layer is reduced, and the overall stability and open circuit voltage of the perovskite solar cell are improved, thus the photoelectric conversion efficiency of the perovskite solar cell is improved.

In some embodiments, the perovskite solar cell further includes an electron transport layer. The perovskite layer includes a first surface and a second surface opposite to each other in the thickness direction thereof. The electron transport layer is provided on the first surface. The hole transport layer is provided on the second surface, and the passivation layer is provided between the hole transport layer and the perovskite layer.

Optionally, the perovskite solar cell may further include a hole blocking layer located on the side of the electron transport layer facing away from the perovskite layer.

As a light absorption layer, the perovskite layer can convert photons into holes and electrons. The material thereof can be selected from conventional materials in the art, which will not be limited herein. The chemical formula of the perovskite layer satisfies ABX₃ or A₂CDX₆, wherein A is an inorganic or organic or organic-inorganic mixed cation, and can be at least one of CH₃NH₃ (MA), CH(NH₂)₂ (FA), and Cs; B is an inorganic or organic or organic-inorganic mixed cation, and can be at least one of Pb and Sn; C is an inorganic or organic or organic-inorganic mixed cation, such as Ag⁺; D is an inorganic or organic or organic-inorganic mixed cation, and can be at least one of a bismuth cation Bi³⁺, an antimony cation Sb³⁺ and an indium cation In³⁺; and X is an inorganic or organic or organic-inorganic mixed anion, and may be at least one of Br or I. Optionally, the perovskite layer has a band gap of 1.20-2.30 eV. Optionally, the perovskite layer has a thickness of 200 nm-1000 nm.

As a transport layer, the electron transport layer can effectively transport electrons, such that the carrier recombination at the interface between the perovskite layer and the electron transport layer is reduced, and the photoelectric conversion efficiency of the perovskite solar cell is improved. The electron transport layer may further include at least one of the following materials and derivatives thereof, or materials obtained by means of doping or passivation: methyl [6,6]-phenyl C₆₁ butyrate (PC₆₁BM), methyl [6,6]-phenyl C₇₁ butyrate (PC₇₁BM), fullerene C60 (C60), fullerene C70 (C70), tin dioxide (SnO₂), zinc oxide (ZnO), etc.

As a transport layer, the hole transport layer can effectively transport holes, such that the carrier recombination at the interface between the perovskite layer and the hole transport layer is reduced, and the photoelectric conversion efficiency of the perovskite solar cell is improved. The material of the hole transport layer includes a nickel oxide. Optionally, the method for preparing the nickel oxide hole transport layer includes but is not limited to a sol method, a sputtering method, a nickel oxide nanoparticle spin-coating method, a knife coating method, a slit coating method, etc.

The passivation layer can be coated on the surface of the nickel oxide hole transport layer by means of dissolving the polymer in an organic solvent and spin coating, spray coating, knife coating or slit coating same. The organic solvent can be methanol, isopropanol, ethanol, chlorobenzene, etc., with a concentration of 0.1-10 mg/mL. The polymer can form a passivation layer with a thickness of 0.1 nm to 5 nm, optionally 1 nm to 3 nm on the surface of the nickel oxide hole transport layer. In addition, the organic solvent can be removed from the passivation layer by means of annealing or vacuum.

When the thickness of the passivation layer is within the above ranges, the polymer can basically formed on the surface of the nickel oxide hole transport layer in the form of a monomolecular layer, and the polymer is spread relatively uniformly. The moderate thickness of the passivation layer is conducive to the transport of holes and is conducive to the uniform and whole coverage on the nickel oxide hole transport layer, thereby completely passivating the trivalent nickel at the surface of the nickel oxide.

In some embodiments, the perovskite solar cell further includes a first electrode and a second electrode. At least one of the first electrode and the second electrode is a transparent conductive glass electrode. As an example, the transparent conductive glass electrode is FTO, ITO, AZO, BZO, IZO, etc. The material of the other electrode may be an organic or inorganic or organic-inorganic mixed conductive material, including but not limited to the following materials: Ag, Cu, C, Au, Al, ITO, AZO, BZO, IZO etc.

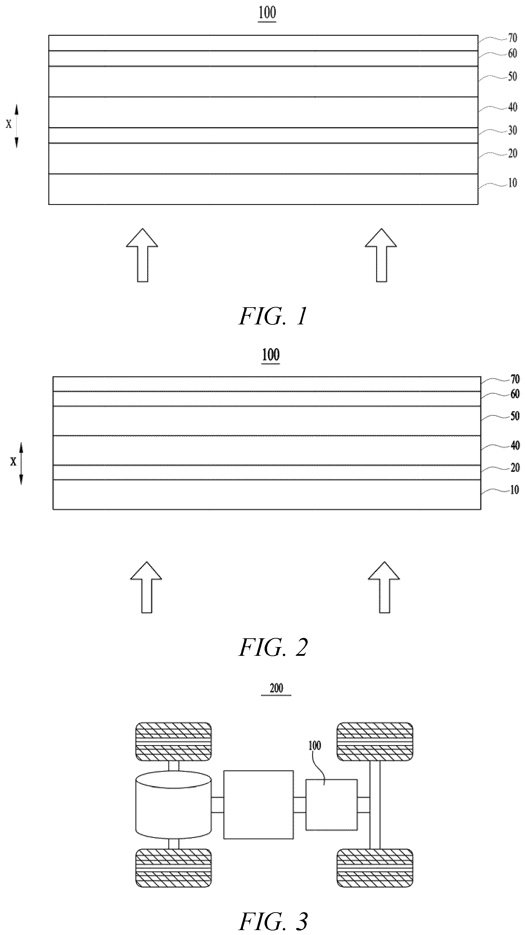

Fig. 1 shows a structural schematic diagram of a perovskite solar cell provided in some embodiments of the present application. As shown in Fig. 1, the perovskite solar cell 100 includes a transparent electrode 10, a hole transport layer 20, a passivation layer 30, a perovskite layer 40, an electron transport layer 50 and a metal electrode 70 provided in sequence in the thickness direction X thereof. The arrows in Fig. 1 represent the incident direction of light.

The perovskite solar cell is prepared as follows:
Step S1: providing a transparent conductive glass substrate, and etching, cleaning and drying the transparent conductive glass substrate;
Step S2: preparing a nickel oxide hole transport layer on the dried transparent conductive glass electrode;
Step S3: covering the surface of the nickel oxide hole transport layer facing away from the transparent conductive glass electrode with the polymer, and removing a solvent by means of annealing or vacuum to obtain a passivation layer;
Step S4: preparing a perovskite layer on the surface of the passivation layer facing away from the transparent conductive glass electrode;
Step S5: preparing an electron transport layer on the surface of the perovskite layer facing away from the transparent conductive glass electrode; and
Step S6: preparing a metal electrode on the surface of the electron transport layer facing away from the transparent conductive glass electrode, and encapsulating same to obtain a perovskite solar cell.

Further, the perovskite solar cell 100 may further include a buffer layer 60. The buffer layer 60 may transport electrons and block holes. The material of the buffer layer may be 2-(4-tert-butylphenyl)-5-(4-biphenyl)-1,3,4-oxadiazole, bis(8-hydroxyl)-2-methylquinoline)-(4-phenylphenoxy)aluminum, etc. Of course, the buffer layer 60 may not be provided in the perovskite solar cell 100.

### Perovskite solar cell

In a third aspect, the present application further provides a perovskite solar cell. The perovskite solar cell includes a hole transport layer comprising a polymer according to any one of embodiments of the first aspect of the present application.

In some embodiments, the perovskite solar cell further includes a perovskite layer. The hole transport layer has an LUMO energy level greater than the LUMO energy level of the perovskite layer.

In some embodiments, the difference between the LUMO energy level of the perovskite layer and the LUMO energy level of the hole transport layer is within 0.5 eV; and optionally, the difference between the LUMO energy level of the perovskite layer and the LUMO energy level of the hole transport layer is within 0.3 eV.

The difference between the LUMO energy level of the perovskite layer and the LUMO energy level of the hole transport layer satisfies the above conditions, such that the above polymer can be used as a hole transport layer. Moreover, the polymer can effectively extract holes and block the electron transport, and has a relatively high hole migration rate.

In some embodiments, the hole transport layer has a thickness of 10 nm to 50 nm; optionally, 15 nm to 30 nm. When the thickness of the hole transport layer is within the above ranges, the hole transport capability thereof can be further improved.

In some embodiments, the perovskite solar cell further includes an electron transport layer, the specific material of which is as described above, and will not be described herein again.

In some embodiments, the perovskite solar cell further includes a first electrode and a second electrode. At least one of the first electrode and the second electrode is a transparent conductive glass electrode, the specific material of which is as described above, and will not be described herein again.

Fig. 2 shows a structural schematic diagram of a perovskite solar cell provided in some embodiments of the present application. As shown in Fig. 2, the perovskite solar cell 100 includes a transparent electrode 10, a hole transport layer 20, a perovskite layer 40, an electron transport layer 50 and a metal electrode 70 provided in sequence in the thickness direction X thereof. The arrows in Fig. 2 represent the incident direction of light.

The perovskite solar cell is prepared as follows:
Step S1: providing a transparent conductive glass substrate, and etching, cleaning and drying the transparent conductive glass substrate;
Step S2: covering the surface of the transparent conductive glass electrode with the polymer, and removing a solvent by means of annealing or vacuum to obtain a hole transport layer;
Step S3: preparing a perovskite layer on the surface of the hole transport layer facing away from the transparent conductive glass electrode;
Step S4: preparing an electron transport layer on the surface of the perovskite layer facing away from the transparent conductive glass electrode; and
Step S5: preparing a metal electrode on the surface of the electron transport layer facing away from the transparent conductive glass electrode, and encapsulating same to obtain a perovskite solar cell.

Further, the perovskite layer 40 may further include a buffer layer 60.

### Photovoltaic module

In a fourth aspect, the present application further provides a photovoltaic module, including a perovskite solar cell according to any one of embodiments of the second aspect or the third aspect of the present application. The perovskite solar cell can be used as a power supply for the photovoltaic module, or can also be used as an energy storage unit for the photovoltaic module. One or more perovskite solar cells can be provided. When a plurality of perovskite solar cells are provided, the plurality of perovskite solar cells can be connected in series or in parallel or in series-parallel to form a photovoltaic module; the plurality of perovskite solar cells can also be first connected in series or in parallel or in series-parallel to form a cell unit, and a plurality of cell units are then connected in series or in parallel or in series-parallel to form a whole.

### Power consuming device

In a fifth aspect, the present application further provides a power consuming device, including a perovskite solar cell according to any one of embodiments of the second and third aspects of the present application or a photovoltaic module according to any one of embodiments of the fourth aspect of the present application.

The perovskite solar cell or photovoltaic module can be used as a power supply for the power consuming device, or can also be used as an energy storage unit for the power consuming device. The power consuming device may be, but is not limited to, a mobile apparatus (e.g., a mobile phone, a laptop computer, etc.), an electric vehicle (e.g., a pure electric vehicle, a hybrid electric vehicle, a plug-in hybrid electric vehicle, an electric bicycle, an electric scooter, an electric golf vehicle, an electric truck, etc.), an electric train, a ship, a satellite, an energy storage system, etc.

A secondary battery, battery module or battery pack may be used for the power consuming device according to the usage requirements thereof.

Fig. 3 shows a schematic diagram of a power consuming device as an example. The power consuming device 200 may be a pure electric vehicle, a hybrid electric vehicle, a plug-in hybrid electric vehicle, etc. In order to meet the requirements of the power consuming device for a high power and a high energy density, the perovskite solar cell 100 may be used.

### Examples

The following examples more specifically describe the content disclosed in the present application, and these examples are only used for explanatory description, because various modifications and changes within the scope of the present disclosure are obvious to those skilled in the art. Unless otherwise noted, all parts, percentages and ratios reported in the following examples are on a weight basis, and all reagents used in the examples are commercially available or are synthesized according to conventional methods, and can be used directly without further treatment, and the instruments used in the examples are commercially available.

### Examples

### Example A

### Preparation of polymer

### (1) Synthesis of 9-(2-bromoethyl)-9H-carbazole

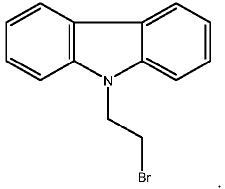

1.672 g carbazole was dissolved in 25 mL of 1,2-dibromoethane, and stirred to mix same until uniform, followed by adding 0.5 g of tetrabutylammonium bromide and 3 mL of a 50 wt% KOH aqueous solution, heating same to 50°C and stirring same for 72 h, and then the reaction was stopped, the product was extracted with dichlorine, and the organic phase was dried with anhydrous MgSO4, followed by rotary evaporation to remove the solvent, so as to obtain a crude product, which was purified by a column to obtain 9-(2-bromoethyl)-9H-carbazole, wherein a mobile phase was a mixture of acetone and n-hexane with a volume ratio of 1 : 10.

### (2) Synthesis of diethyl 2-(9H-carbazol-9-ethyl)phosphonate

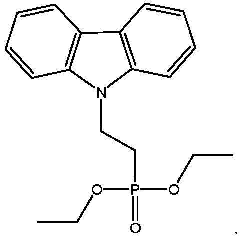

1 g of 9-(2-bromoethyl)-9H-carbazole was dissolved in 15 mL of triethyl phosphite, heated and refluxed, and reacted for 24 h. Most of the organic solvent was removed by means of rotary evaporation after the reaction, and the product was purified by a column to obtain diethyl 2-(9H- carbazol-9-ethyl)phosphonate, wherein a mobile phase was a mixture of acetone and n-hexane with a volume ratio of 1 : 4.

### (3) Synthesis of diethyl (2-(3,6-dibromo-9H-fluoren-9-yl) ethyl)phosphonate

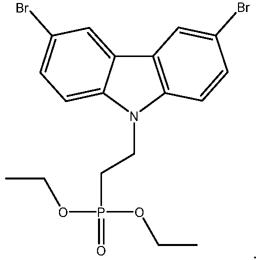

Diethyl 2-(9H-carbazol-9-ethyl)phosphonate (4.88 g, 10 mmol) was placed into a round-bottomed flask, N-bromosuccinimide NBS (5.4 g, 30 mmol) was added, the mixture was reacted at 0°C for 4 h, then the product after the reaction was washed with water and, respectively, the organic phase was extracted with chloroform, and the organic phases were combined, water was removed by means of anhydrous magnesium sulfate, and the solvent was removed by means of rotary evaporation, so as to give a product of diethyl (2-(3,6-dibromo-9H-fluoren-9-yl)ethyl)phosphonate.

### (4) Synthesis of diethyl (2-(3,6-bis(4,4,5,5-tetramethyl-1,3,2-dioxybenzaldehyde-2-yl)-9H-fluoren-9-yl)ethyl)phosphonate

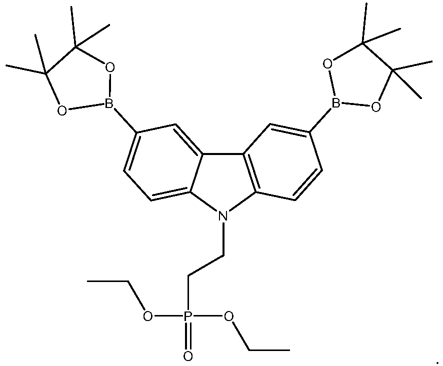

Diethyl (2-(3,6-dibromo-9H-fluoren-9-yl)ethyl)phosphonate (2.91 g, 5 mmol) was dissolved in 20 mL of tetrahydrofuran, argon was introduced and discharged to allow same under an argon atmosphere and same was stirred at -78°C for 0.5 h, then butyl lithium (1 mL, 2.5 M in n-hexane) was slowly added dropwise into the above system, stirred continuously for 1 h after the dropwise addition is completed, 2-isopropoxy-4,4,5,5-tetramethyl-1,3,2-dioxaborane (0.37 g, 20 mmol) was added dropwise, reacted at -78°C for 1 h, and then heated to room temperature, the product after the reaction was poured into deionized water, and then extracted with chloroform for three times, the organic phases were separated, the organic phases were combined, water was removed by means of anhydrous magnesium sulfate, the solvent was removed by means of rotary evaporation, the product was recrystallized with isopropanol, and the precipitate was dissolved in chloroform and precipitated by adding methanol to give a purer product, diethyl (2-(3,6-bis(4,4,5,5-tetramethyl-1,3,2-dioxybenzaldehyde-2-yl)-9H-fluoren-9-yl) ethyl)phosphonate.

### (5) Synthesis of poly[diethyl (2-(3,6-dimethyl-9H-fluoren-9-yl)ethyl)phosphonate]:

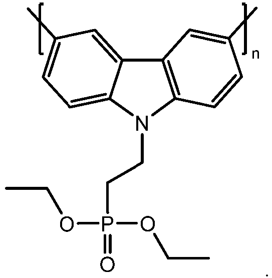

100 mL of toluene was added to a clean and dry round-bottomed flask, diethyl (2-(3,6-dibromo-9H-fluoren-9-yl)ethyl)phosphonate prepared in step (3) (0.95 g, 1.18 mmol), diethyl (2-(3,6-bis(4,4,5,5-tetramethyl-1,3,2-dioxybenzaldehyde-2-yl)-9H-fluoren-9-yl) ethyl) phosphonate prepared in step (4) (0.69 g, 1.18 mmol), tris(dibenzylidene-BASE acetone)dipalladium Pd2(dba)3 (54 mg, 0.06 mmol), triphenylphosphine PPh3 (54 mg, 0.18 mmol), 2.5 mL of a 1 M aqueous potassium carbonate solution, and 0.005 mL of methyltrioctylammonium chloride were mixed in the round-bottomed flask, argon was evacuated to ensure an argon environment, the mixture was reacted at 90°C for 5 h, then phenylboronic acid pinacol ester (24 mg, 1.2 mmol) was added and stirred continuously for 20 min, then bromobenzene (0.3 g, 1.9 mmol) was added and stirred continuously for 20 min, and cooled to room temperature, the product was washed with water, the organic phase was extracted with chloroform, the organic phases were mixed, water was removed with anhydrous magnesium sulfate, most of the solvent is removed by rotary evaporation for saturating the product in toluene, the toluene solution of the product was added dropwise to 500 mL of methanol, the solid part was obtained by suction filtration, wrapped in a filter paper, and extracted by a Soxhlet extractor with methanol, acetonitrile, and chloroform, respectively, the chloroform phase was separated and concentrated to obtain a saturated solution, and the saturated solution was added dropwise to 500 mL of methanol, and was filtered by suction to obtain a solid part, 0.5 g of poly[diethyl (2-(3,6-dimethyl-9H-fluoren-9-yl)ethyl) phosphonate].

### (6) Synthesis of poly[diethyl(2-(3,6-dimethyl-9H-fluoren-9-yl)phosphonic acid],

the repeating unit thereof being of formula (I-33),

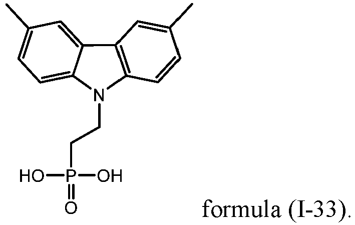

Under an argon atmosphere, 0.5 g (6) was dissolved in anhydrous 1,4-dioxane (15 ml) and bromotrimethylsilane (1.73 ml, 13.07 mmol) was added dropwise. The reaction was stirred under the argon atmosphere at 25°C for 22 h. Then, methanol (3 ml) was added and stirred continuously for 3 h. Finally, distilled water (10 ml) was added dropwise until the solution was opaque, and same was stirred overnight. The product was filtered off, washed with water, dissolved in tetrahydrofuran (1 ml) and precipitated into n-hexane (12 ml). The product was filtered off and washed with n-hexane to obtain 0.360 g of poly[diethyl(2-(3,6-dimethyl-9H-fluoren-9-yl)phosphonic acid].

### Example B

### Synthesis of polymer

### Synthesis of methyl 3-(9H-carbazol-9-yl)propionate

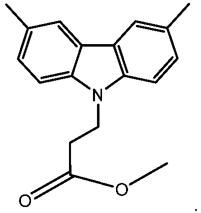

In a clean and dry round-bottomed flask, 8.3605 g (0.05 mol) of carbazole, 12.52 g (0.075 mol) of methyl 3-bromopropionate, 1 g of Pd2(dba)3, 5 mL of tritert-butylphosphine, 32 g of cesium carbonate were added, and then 100 mL of toluene was added, the (nitrogen) gas was evacuated for three times to maintain a nitrogen environment in the flask, the materials were reacted at 110°C for 20 h, a product was extracted with dichlorine, and the organic phase was dried with anhydrous MgSO4, followed by rotary evaporation to remove the solvent, so as to obtain a crude product, which was purified by a column to obtain methyl 3-(9H-carbazol-9-yl)propionate, wherein the mobile phase was a mixture of ethyl acetate and n-hexane with a volume ratio of 1 : 10, and the product was 7.52 g (59%).

### Synthesis of methyl 3-(3,6-dibromo-9H-carbazol-9-yl)propionate

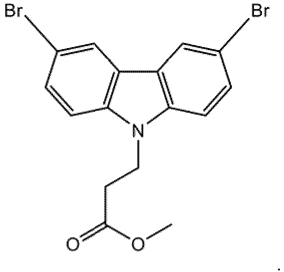

methyl 3-(9H-carbazol-9-yl)propionate (2.53 g, 10 mmol) was placed into a round-bottomed flask, N-bromosuccinimide NBS (5.4 g, 30 mmol) was added, the mixture was reacted at 0°C for 4 h, then the product after the reaction was washed with water and, respectively, the organic phase was extracted with chloroform, and the organic phases were combined, water was removed by means of anhydrous magnesium sulfate, and the solvent was removed by means of rotary evaporation, so as to give a product of methyl 3-(3,6-dibromo-9H-carbazol-9-yl)propionate.

### Synthesis of methyl 3-(3,6-bis(4,4,5,5-tetramethyl-1,3,2-dioxybenzofuran-2-yl)-9H-carbazol-9-yl)propionate

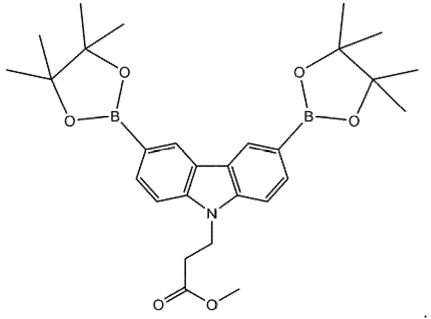

Methyl 3-(3,6-dibromo-9H-carbazol-9-yl)propionate (2.04 g, 5 mmol) was dissolved in 20 mL of tetrahydrofuran, argon was introduced and discharged to allow same under an argon atmosphere, and same was stirred at -78°C for 0.5 h, then butyl lithium (1 mL, 2.5 M in n-hexane) was slowly added dropwise into the above system, stirred continuously for 1 h after the dropwise addition is completed, 2-isopropoxy-4,4,5,5-tetramethyl-1,3,2-dioxaborane (0.37 g, 20 mmol) was added dropwise, reacted at -78°C for 1 h, and then heated to room temperature, the product after the reaction was poured into deionized water, and then extracted with chloroform for three times, the organic phases were separated, the organic phases were combined, water was removed by means of anhydrous magnesium sulfate, the solvent was removed by means of rotary evaporation, the product was recrystallized with isopropanol, and the precipitate was dissolved in chloroform and precipitated by adding methanol to give a purer product, methyl 3-(3,6-bis(4,4,5,5-tetramethyl-1,3,2-dioxybenzofuran-2-yl)-9H-carbazol-9-yl)propionate.

### Synthesis of poly[methyl 3-(3,6-bis(4,4,5,5-tetramethyl-1,3,2-dioxybenzofuran-2-yl)-9H-carbazol-9-yl)propionate]:

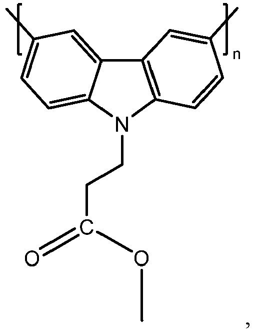

the repeating unit thereof being of formula (I-36).

100 mL of toluene was added to a clean and dry round-bottomed flask, and methyl 3-(3,6-dibromo-9H-carbazol-9-yl)propionate prepared in step (2) (0.48 g, 1.18 mmol), methyl 3-(3,6-bis(4,4,5,5-tetramethyl-1,3,2-dioxybenzofuran-2-yl)-9H-carbazol-9-yl)propionate prepared in step (3) (0.6 g, 1.18 mmol), tris(dibenzylidene-BASE acetone)dipalladium Pd2(dba)3 (54 mg, 0.06 mmol), triphenylphosphine PPh3 (54 mg, 0.18 mmol), 2.5 mL of a 1 M aqueous potassium carbonate solution, and 0.005 mL of methyltrioctylammonium chloride were mixed in the round-bottomed flask, the gas was evacuated to ensure an argon environment, the mixture was reacted at 90°C for 5 h, then phenylboronic acid pinacol ester (24 mg, 1.2 mmol) was added and stirred continuously for 20 min, then bromobenzene (0.3 g, 1.9 mmol) was added and stirred continuously for 20 min, and cooled to room temperature, the product was washed with water, the organic phase was extracted with chloroform, the organic phases were mixed, water was removed with anhydrous magnesium sulfate, most of the solvent is removed by rotary evaporation for saturating the product in toluene, the toluene solution of the product was added dropwise to 500 mL of methanol, the solid part was obtained by suction filtration, wrapped in a filter paper, and extracted by a Soxhlet extractor with methanol, acetonitrile, and chloroform, respectively, the chloroform phase was separated and concentrated to obtain a saturated solution, and the saturated solution was added dropwise to 500 mL of methanol, and was filtered by suction to obtain a solid part, poly[methyl 3-(3,6-bis(4,4,5,5-tetramethyl-1,3,2-dioxybenzofuran-2-yl)-9H-carbazol-9-yl)propionate].

### Synthesis of poly[3-(3,6-bis(4,4,5,5-tetramethyl-1,3,2-dioxybenzofuran-2-yl)-9H-carbazol-9-yl)propane acid

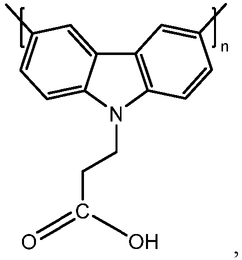

the repeating unit thereof being (I-35).

Under an argon atmosphere, 0.5 g (4) was dissolved in anhydrous 1,4-dioxane (15 ml) and bromotrimethylsilane (1.73 ml, 13.07 mmol) was added dropwise. The reaction was stirred under the argon atmosphere at 25°C for 22 h. Then, methanol (3 ml) was added and stirred continuously for 3 h. Finally, distilled water (10 ml) was added dropwise until the solution was opaque, and same was stirred overnight. The product was filtered off, washed with water, dissolved in tetrahydrofuran (1 ml) and precipitated into n-hexane (12 ml). The product was filtered off and washed with n-hexane to obtain poly[3-(3,6-bis(4,4,5,5-tetramethyl-1,3,2-dioxybenzofuran-2-yl)-9H -carbazol-9-yl)propionic acid.

### Example D

### Synthesis of poly[2-((2,4-dimethylphenyl)(p-tolyl)amino)ethane-1-sulfonic acid], the repeating unit thereof being of formula (I-40),

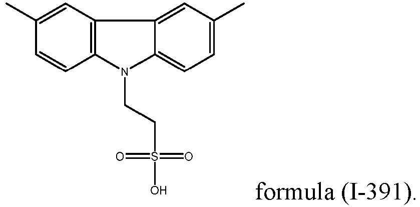

The difference, compared to Example A, was that the process of step (1) was as follows: 3.26 g (20 mmol) of 2-chloroethanesulfonyl chloride, 1.2 g (20 mmol) of isopropanol and 40 ml of 1,2-dichloroethane were mixed in the round-bottomed flask 1, and cooled to 0°C. 3.34 g (20 mmol) of carbazole was weighed to another flask, dissolved in 20 ml of 1,2-dichloroethane, and stirred fully until same is completely dissolved to obtain a carbazole solution. The carbazole solution was added dropwise to the round-bottomed flask 1, the reaction temperature was returned to room temperature after the dropwise addition is completed, and the reaction was continued for 4 h. Filtration, drying and concentration were carried out, and then a crude product was purified by a column. The mobile phase was a mixture of dichloromethane and n-hexane with a volume ratio of 1 : 8. A product of isopropyl 2-(phenyl(o-tolyl)amino)ethane-1-sulfonate was obtained by purification. The remaining steps were similar to those in Example A.

### Example E

On the basis of Example C, a reaction with sodium hydroxide was carried out to obtain the corresponding sodium salt, the repeating unit of which was of formula (I-39),

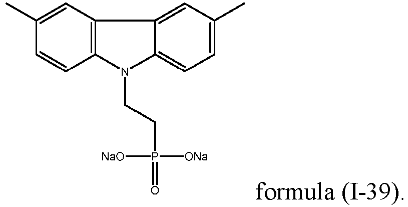

### Example F

A polymer was prepared by a method similar to that in Example A, except that in step (1), 1,2-dibromoethane was replaced with 1,2-dibromopropane, and the repeating unit of the polymer was of formula (I-37),

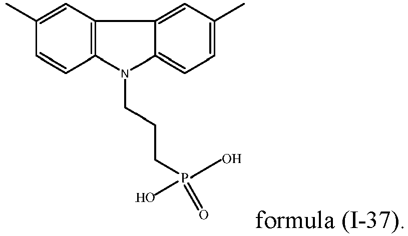

### Example G

A polymer was prepared by a method similar to that in Example A, except that in step (1), 1,2-dibromoethane was replaced with 1,2-dibromooctane, and the repeating unit of the polymer was of formula (I-38),

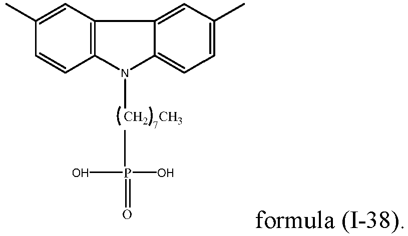

### Example H

A polymer was prepared by a method similar to that in Example A, except that in step (1), carbazole was replaced with diphenylamine, and the repeating unit of the polymer was of formula (I-17),

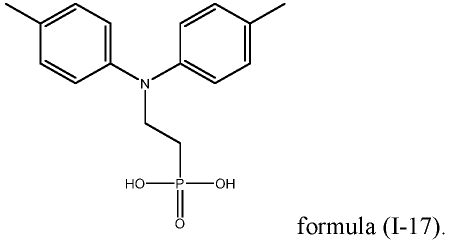

### Example I

A polymer was prepared by a method similar to that in Example A, except that in step (1), carbazole was replaced with N1,N1-diphenylbenzene-1,3-diamine, and the repeating unit of the polymer was of formula (I-29),

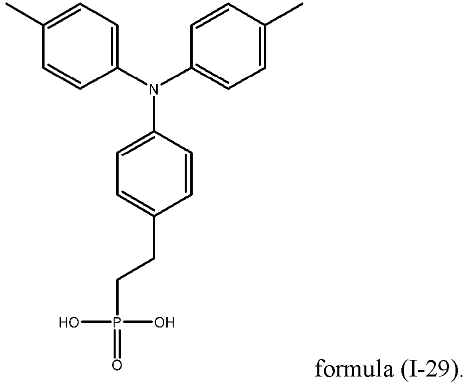

### Example 1

### Preparation of perovskite solar cell

(1) 20 pieces of FTO conductive glass with a size of 2.0 * 2.0 cm were taken, and 0.35 cm FTO was removed from both ends by laser etching to expose a glass substrate;
(2) the etched FTO conductive glass was ultrasonically cleaned several times with water, acetone and isopropanol in sequence;
(3) the FTO conductive glass was blown with a nitrogen gun to remove the solvent and put into an ultraviolet ozone machine for further cleaning;
(4) a hole transport layer of 10 mg/mL of nickel oxide nanoparticles (an aqueous solution as a solvent) was spin-coated on the ultraviolet ozone-treated FTO conductive glass at the rate of 4000 rpm/s, and then annealed on a hot bench at 100°C for 30 minutes;
(5) the polymer prepared in example A was dissolved in chlorobenzene to obtain a polymer solution; and the polymer solution was spin-coated on the nickel oxide hole transport layer at 3000 rpm/s, and vacuumized or annealed to obtain a polymer passivation layer;
(6) lead iodide, iodoformamidine, cesium iodide, bromomethylamine and lead bromide were weighed and dissolved in a mixture of DMF and DMSO, stirred for 3 h, and filtered with a 0.22 µm organic filter membrane, so as to obtain a perovskite precursor solution, and the perovskite precursor solution was spin-coated on the obtained polymer passivation layer at 3000 rpm/s, annealed at 100°C for 30 min, and cooled to room temperature, wherein the active substance of the perovskite layer is a CsFAMA system;
(7) an electron transport layer PCBM was spin-coated on the perovskite layer at 1500 rpm/s, annealed at 100°C for 10 min, and then a buffer layer BCP thereof was spin-coated at 5000 rpm/s; and
(8) the device obtained above was placed into an evaporator for evaporating a metal electrode of Ag to obtain the perovskite solar cell.

### Example 2

In example 2, a perovskite solar cell was prepared by a method similar to that in example 1, except that in example 2, the polymer prepared in example B was used as a passivation layer material.

### Example 3

In example 3, a perovskite solar cell was prepared by a method similar to that in example 1, except that in example 3, the polymer prepared in example C was used as a passivation layer material.

### Example 4

In example 4, a perovskite solar cell was prepared by a method similar to that in example 1, except that in example 4, the polymer prepared in example D was used as a passivation layer material.

### Example 5

In example 5, a perovskite solar cell was prepared by a method similar to that in example 1, except that in example 5, the polymer prepared in example E was used as a passivation layer material.

### Example 6

In example 6, a perovskite solar cell was prepared by a method similar to that in example 1, except that in example 6, the polymer prepared in example F was used as a passivation layer material.

### Example 7

In example 7, a perovskite solar cell was prepared by a method similar to that in example 1, except that in example 7, the polymer prepared in example G was used as a passivation layer material.

### Example 8

In example 8, a perovskite solar cell was prepared by a method similar to that in example 1, except that in example 8, the polymer prepared in example H was used as a passivation layer material.

### Example 9

In example 9, a perovskite solar cell was prepared by a method similar to that in example 1, except that in example 9, the polymer prepared in example I was used as a passivation layer material.

### Comparative example 1

In comparative example 1, a perovskite solar cell was prepared by a method similar to that in example 1, except that in comparative example 1, a passivation layer was not provided.

### Comparative example 2

In comparative example 2, a perovskite solar cell was prepared by a method similar to that in example 1, except that in comparative example 2, the monomer diethyl (2-(3,6-dimethyl-9H-fluoren-9-yl)phosphonic acid of the polymer in example A was used as a passivation layer material.

### Comparative example 3

In comparative example 3, a perovskite solar cell was prepared by a method similar to that in example 1, except that in comparative example 3, polystyrene was used as a passivation layer material.

### Properties of cells of examples 1 to 11 and comparative examples are as shown in tables 1 and 2:

**Table 1**

| Item | Passivation layer | | Hole transport layer | Perovskite layer | E3-E1 (ev) | E2-E1 (ev) |
|---|---|---|---|---|---|---|
| | Material | HOMO E1 (eV) | HOMO E2 (eV) | HOMO E3 (eV) | | |
| Example 1 | Example A | -5.3 | -5.2 | -5.6 | -0.3 | 0.1 |
| Example 2 | Example B | -5.3 | -5.2 | -5.6 | -0.3 | 0.1 |
| Example 3 | Example C | -5.3 | -5.2 | -5.6 | -0.3 | 0.1 |
| Example 4 | Example D | -5.2 | -5.2 | -5.6 | -0.4 | 0 |
| Example 5 | Example E | -5.4 | -5.2 | -5.6 | -0.2 | 0.2 |
| Example 6 | Example F | -5.3 | -5.2 | -5.6 | -0.3 | 0.1 |
| Example 7 | Example G | -5.4 | -5.2 | -5.6 | -0.2 | 0.2 |
| Example 8 | Example H | -5.5 | -5.2 | -5.6 | -0.1 | 0.3 |
| Example 9 | Example I | -5.4 | -5.2 | -5.6 | -0.2 | 0.2 |
| Comparative example 1 | None | / | -5.2 | -5.6 | / | / |
| Comparative example 2 | diethyl (2-(3,6-dimethyl-9H-fluoren-9-yl)phosphonic acid | -5.7 | -5.2 | -5.6 | 0.1 | 0.5 |
| Comparative example 3 | Polystyrene | -5.8 | -5.2 | -5.6 | 0.2 | 0.6 |

**Table 2**

| Item | | Cell efficiency test |
|---|---|---|
| | Day 3 efficiency % | Day 30 efficiency % |
| Example 1 | 18.92 | 18.88 |
| Example 2 | 18.76 | 18.69 |
| Example 3 | 18.76 | 18.69 |
| Example 4 | 18.80 | 18.79 |
| Example 5 | 18.82 | 18.83 |
| Example 6 | 18.88 | 18.79 |
| Example 7 | 18.54 | 18.42 |
| Example 8 | 18.49 | 18.33 |
| Example 9 | 18.67 | 18.7 |
| Comparative example 1 | 17.86 | 15.23 |
| Comparative example 2 | 17.88 | 17.79 |
| Comparative example 3 | 16.89 | 16.66 |

From tables 1 and 2, it can be seen that as compared with comparative example 1, in comparative example 2, diethyl (2-(3,6-dimethyl-9H-fluoren-9-yl)phosphonic acid was provided on the surface of the nickel oxide layer, which can have a passivation effect on high-valent nickel but the effect thereof was little. In contrast, in comparative example 3, a polystyrene layer was provided on the surface of the nickel oxide layer, which not only fails to passivate the high-valent nickel, but may deteriorate the efficiency of a cell. According to the embodiments of the present application, by providing a specific polymer on the surface of the nickel oxide layer, the high-valence nickel can be significantly passivated, and the hole transport performance and electron transport blocking ability can be improved, such that the photoelectric conversion efficiency of perovskite solar cells is effectively improved.

### Examples 10 and 11

In examples 10 and 11, a perovskite solar cell was prepared by a method similar to that in example 1, except that in examples 10 and 11, the polymer prepared in example A was used as a passivation layer material, and polymers with different molecular weights can be separated by different solvents.

Relevant parameters of examples 1, 10, and 11 were as shown in tables 3 and 4:

**Table 3**

| Item | Passivation layer | | Nickel oxide hole transport layer | Perovskite layer | E3-E1 (ev) | E2-E1 (ev) |
|---|---|---|---|---|---|---|
| | Material | LUMO E1 (eV) | LUMO E2 (eV) | LUMO E3 (eV) | | |
| Example 1 | Example A | -5.3 | -5.2 | -5.6 | -0.3 | 0.1 |
| Example 10 | Example A | -5.3 | -5.2 | -5.6 | -0.3 | 0.1 |
| Example 11 | Example A | -5.3 | -5.2 | -5.6 | -0.3 | 0.1 |

**Table 4**

| Item | Passivation layer | Polymer molecular weight | Passivation layer thickness, nm | Cell efficiency test | |
|---|---|---|---|---|---|
| | | | | Day 3 efficiency % | Day 30 efficiency % |
| Example 1 | Example A | 3000-5000 | 3nm | 18.92 | 18.88 |
| Example 10 | Example A | 5000-7000 | 3nm | 18.93 | 18.92 |
| Example 11 | Example A | 7000-10000 | 5nm | 18.79 | 18.73 |

From tables 3 and 4, it can be seen that the photoelectric conversion efficiency of perovskite solar cells can be fine-adjusted by means of regulating the molecular weight of the polymer.

### Example 12

### Preparation of perovskite solar cell

(1) 20 pieces of FTO conductive glass with a size of 2.0 * 2.0 cm were taken, and 0.35 cm FTO was removed from both ends by laser etching to expose a glass substrate;
(2) the etched FTO conductive glass was ultrasonically cleaned several times with water, acetone and isopropanol in sequence;
(3) the FTO conductive glass was blown with a nitrogen gun to remove the solvent and put into an ultraviolet ozone machine for further cleaning;
(4) the polymer prepared in example A was dissolved in chlorobenzene to obtain a polymer solution; and the polymer solution was spin-coated on the FTO conductive glass at 3000 rpm/s, and vacuumized or annealed to obtain a polymer layer;
(5) lead iodide, iodoformamidine, cesium iodide, bromomethylamine and lead bromide were weighed and dissolved in a mixture of DMF and DMSO, stirred for 3 h, and filtered with a 0.22 µm organic filter membrane, so as to obtain a perovskite precursor solution, and the perovskite precursor solution was spin-coated on the obtained polymer layer at 3000 rpm/s, annealed at 100°C for 30 min, and cooled to room temperature, wherein the active substance of the perovskite layer is a CsFAMA system;
(6) an electron transport layer PCBM was spin-coated on the perovskite layer at 1500 rpm/s, annealed at 100°C for 10 min, and then a buffer layer BCP thereof was spin-coated at 5000 rpm/s; and
(7) the device obtained above was placed into an evaporator for evaporating a metal electrode of Ag to obtain the perovskite solar cell.

### Example 13 to Example 15

In example 13 to example 15, a perovskite solar cell was prepared by a method similar to that in example 12, except that in example 13 to example 15, the polymer prepared in example A was used as a hole transport layer material, but the thickness of the polymer layer was adjusted.

**Table 5**

| Item | Polymer layer | | Nickel oxide hole transport layer | Perovskite layer | E3-E1 (ev) | E2-E 1 (ev) |
|---|---|---|---|---|---|---|
| | Material | LUMO E1 (eV) | LUMO E2 (eV) | LUMO E3 (eV) | | |
| Example 1 | Example A | -5.3 | -5.2 | -5.6 | -0.3 | 0.1 |
| Example 12 | Example A | -5.3 | / | -5.6 | -0.3 | / |
| Example 13 | Example A | -5.3 | / | -5.6 | -0.3 | / |
| Example 14 | Example A | -5.3 | / | -5.6 | -0.3 | / |

**Table 6**

| Item | Passivation layer | Polymer molecular weight | Passivation layer thickness, nm | Cell efficiency test | |
|---|---|---|---|---|---|
| | | | | Day 3 efficiency % | Day 30 efficiency % |
| Example 1 | Example A | 3000-5000 | 3 nm | 18.92 | 18.88 |
| Example 12 | Example A | 3000-5000 | 30 nm | 18.88 | 18.90 |
| Example 13 | Example A | 3000-5000 | 20 nm | 19.03 | 19.01 |
| Example 14 | Example A | 3000-5000 | 50 nm | 18.23 | 18.31 |

From tables 5 and 6, it can be seen that the photoelectric conversion efficiency of perovskite solar cells can be fine-adjusted by means of regulating the molecular weight of the polymer.

### Test part

### 1. Test method for energy band distribution of perovskite solar cell

The energy band distributions of each sublayer in the electron transport layer, the hole transport layer and the perovskite absorption layer obtained were tested by using an ultraviolet photoelectron spectrometer (UPS) and X-ray photoelectron spectrometer (XPS). The test conditions comprise normal temperature, normal pressure and atmospheric environment, and an He I lamp (21.2 eV) was used as a laser source. Exemplarily, UPS and XPS equipment model was Escalab 250Xi (Thermo Scientific).

### 2. Test method for power conversion efficiency of perovskite solar cell

The energy conversion efficiency was obtained by a voltage-current characteristic test, wherein the intensity of the simulated sunlight source is standard AM1.5G, and the test conditions comprise normal temperature, normal pressure, and atmospheric environment. Exemplarily, the test equipment model was Enli IVS-KA5000.

Although the present application has been described with reference to the preferred embodiments, various modifications can be made, and equivalents can be provided to substitute for the components thereof without departing from the scope of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A polymer, comprising repeating units represented by formula (I): -M-R-Y - formula (I),
wherein in the formula (I),
M is selected from substituted or unsubstituted anilino, substituted or unsubstituted carbazolyl, substituted or unsubstituted acridinyl, substituted or unsubstituted phenothiazinyl or substituted or unsubstituted phenoxazinyl;
R is selected from substituted or unsubstituted C1-C10 alkyl;
and Y is selected from carboxyl or a salt thereof, a phosphoric acid group or a salt thereof, or a sulfonic acid group or a salt thereof.

2. The polymer according to claim 1, wherein
R is selected from substituted or unsubstituted C1-C8 alkyl;
optionally, R is selected from substituted or unsubstituted C1-C5 alkyl.

3. The polymer according to claim 1 or 2, wherein the repeating unit represented by formula (I) includes one or more of repeating units represented by formula (I-1) to formula (I-7): 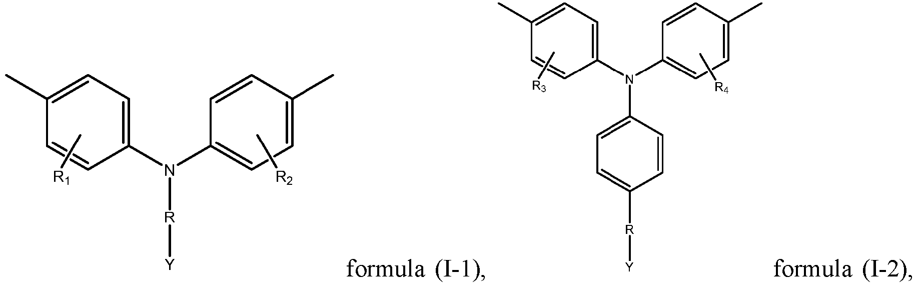 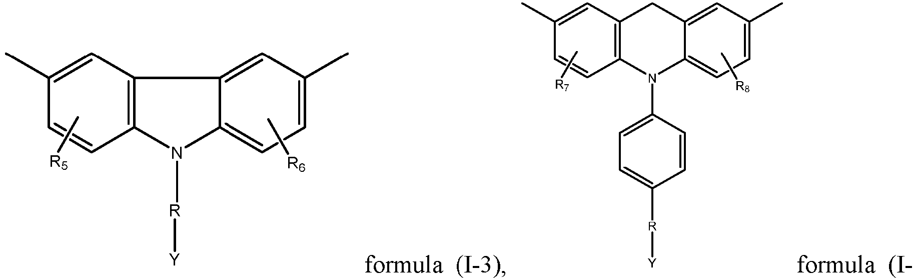 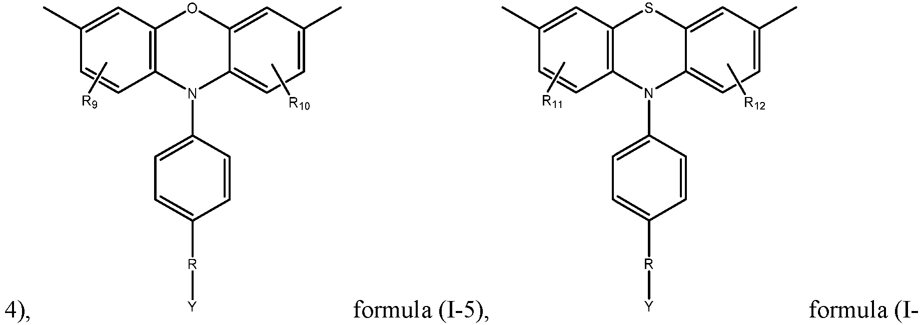 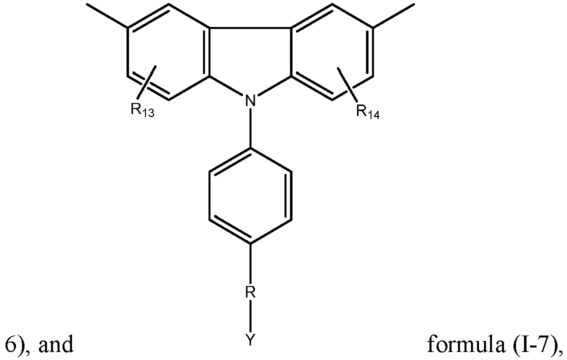 wherein,
R₁ to R₁₄ are each independently selected from a hydrogen atom, a halogen atom, a nitrogen-containing group, hydroxyl, substituted or unsubstituted C1-C5 alkyl, substituted or unsubstituted C1-C5 alkoxy, substituted or unsubstituted C1-C5 amido, a substituted or unsubstituted C1-C5 ester group, substituted or unsubstituted C1-C5 carboxyalkyl or substituted or unsubstituted C6-C20 aryl, optionally, when substituted, the substituent being independently selected from at least one of a halogen atom or a nitrogen-containing group;
and the nitrogen-containing group including C2-C10 dialkylamino, C1-C5 alkylamino, amino, trimethylamino, triethylamino or tripropylamino; and
optionally, R₁ to R₁₄ are each independently selected from a hydrogen atom, a halogen atom, a nitrogen-containing group, hydroxyl, substituted or unsubstituted C1-C5 alkoxy, substituted or unsubstituted C1-C5 amido, a substituted or unsubstituted C1-C5 ester group, or substituted or unsubstituted C1-C5 carboxyalkyl; and
further optionally, R₁ to R₁₄ are each independently selected from a hydrogen atom, substituted or unsubstituted C1-C5 alkoxy or substituted or unsubstituted C1-C5 alkyl.

4. The polymer according to claim 3, wherein Y in the repeating unit represented by formula (I-2) is selected from a phosphoric acid group; and
optionally, the repeating unit represented by formula (I-2) includes at least one of repeating units represented by formula (I-21) to formula (I-29):

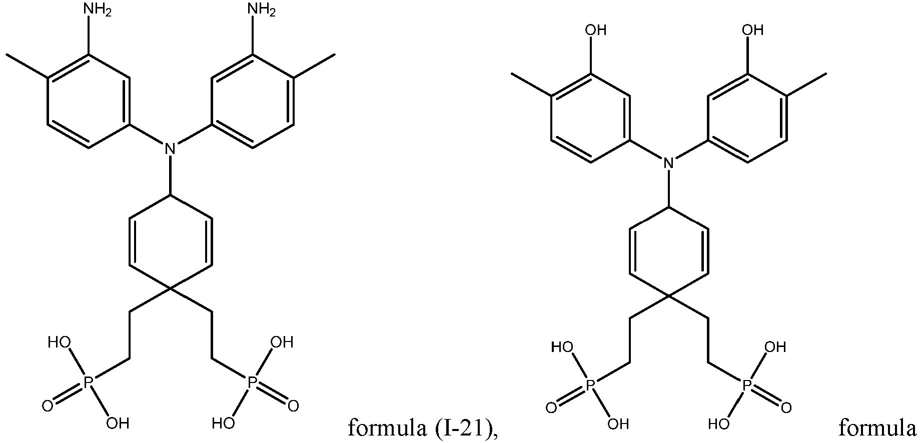

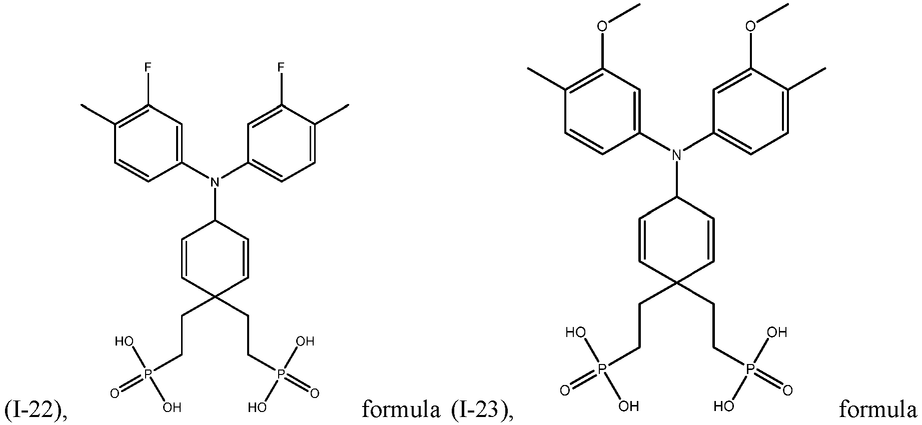

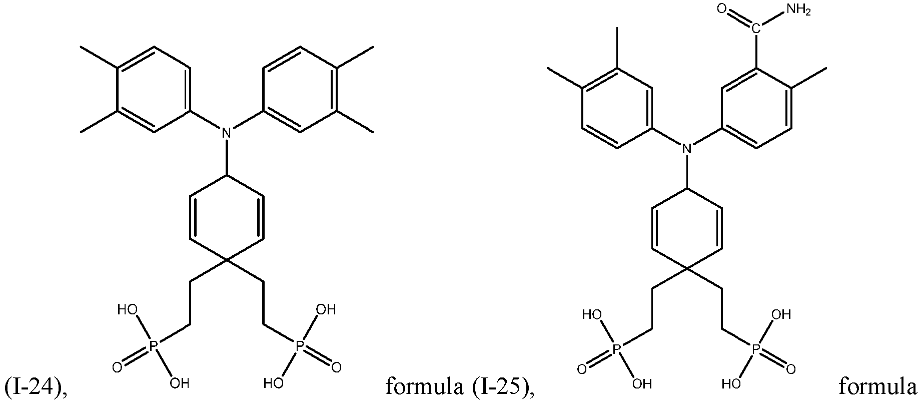

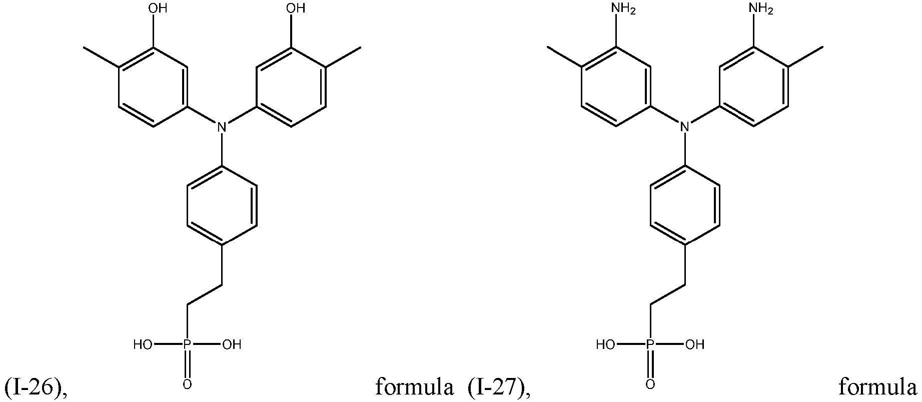

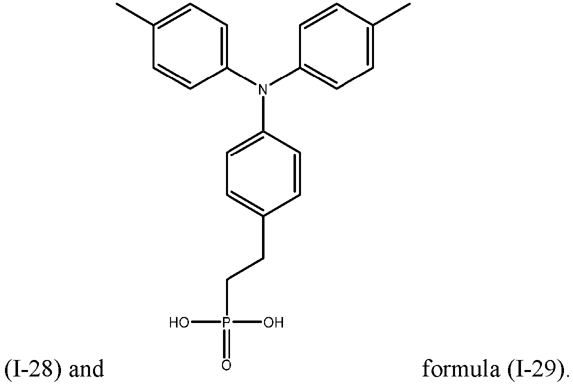

5. The polymer according to claim 3 or 4, wherein the repeating unit represented by formula (I-3) includes at least one of repeating units represented by formula (1-31) to formula (I-391):

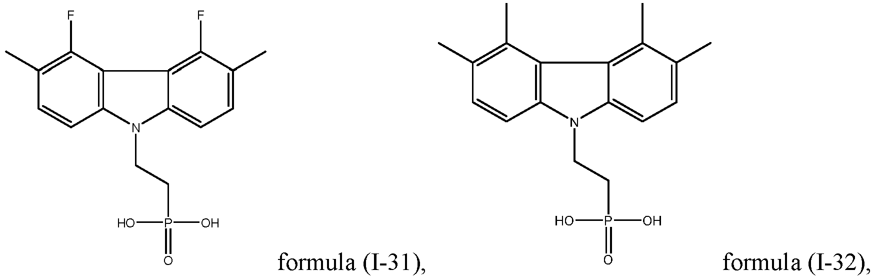

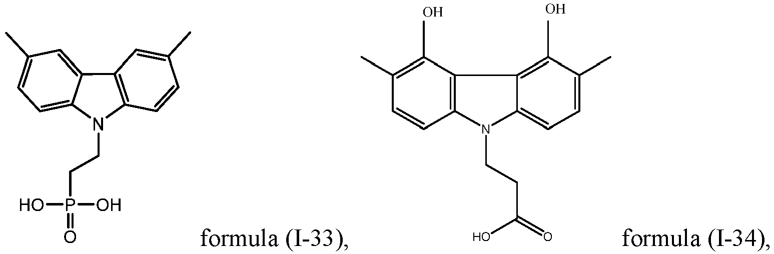

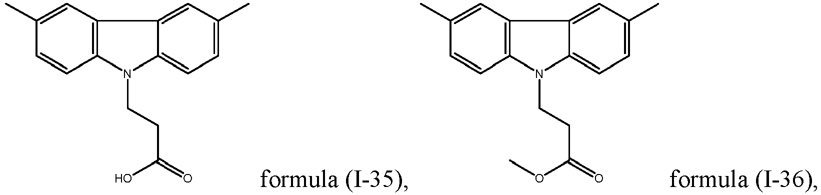

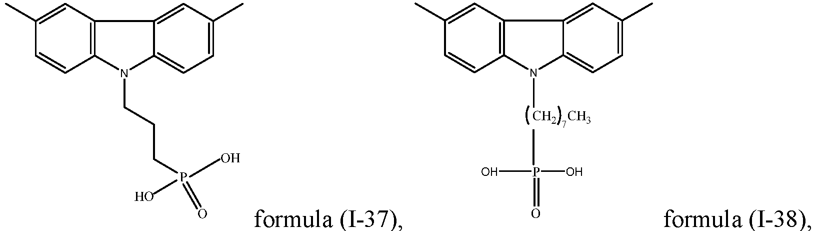

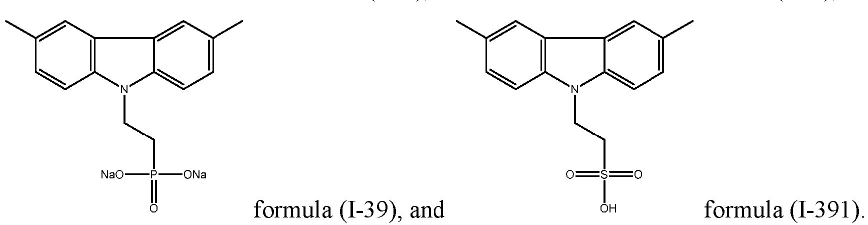

6. The polymer according to any one of claims 1 to 5, wherein
the polymer has a weight average molecular weight of 3000 Da to 20000 Da; optionally, 3000 Da to 10000 Da.

7. A perovskite solar cell, sequentially comprising:
a hole transport layer, a passivation layer and a perovskite layer, wherein the passivation layer comprises a polymer according to any one of claims 1 to 6,
wherein,
the passivation layer has an LUMO energy level greater than the LUMO energy level of the perovskite layer; and
optionally, the LUMO energy level of the passivation layer is located between the LUMO energy level of the perovskite layer and the LUMO energy level of the hole transport layer.

8. The perovskite solar cell according to claim 7, wherein the difference between the LUMO energy level of the perovskite layer and the LUMO energy level of the passivation layer is within 0.5 eV; and
optionally, the difference between the LUMO energy level of the perovskite layer and the LUMO energy level of the passivation layer is within 0.3 eV.

9. The perovskite solar cell according to claim 7 or 8, wherein
the difference between the LUMO energy level of the passivation layer and the LUMO energy level of the hole transport layer is within 0.5 eV; and
optionally, the difference between the LUMO energy level of the passivation layer and the LUMO energy level of the hole transport layer is within 0.3 eV.

10. The perovskite solar cell according to any one of claims 7 to 9, wherein the passivation layer has a thickness of 0.1 nm to 5 nm; optionally, 1 nm to 3 nm.

11. A perovskite solar cell, comprising a hole transport layer, wherein the hole transport layer comprises a polymer according to any one of claims 1 to 6.

12. The perovskite solar cell according to claim 11, wherein the hole transport layer has a thickness of 10 nm to 50 nm; optionally, 15 nm to 30 nm.

13. A photovoltaic module, comprising a perovskite solar cell according to any one of claims 7 to 12.

14. A power consuming device, comprising a perovskite solar cell according to any one of claims 7 to 12 or a photovoltaic module according to claim 13.
